# EUROPÄISCHE PATENTSCHRIFT

(11) **EP 1 363 811 B1**
(45) Veröffentlichungstag und Bekanntmachung des Hinweises auf die Patenterteilung: **22.12.2004**
(21) Anmeldenummer: 02732446.6
(22) Anmeldetag: 22.02.2002
(51) Int. Cl.: B60R 16/02, H05K 3/10

(54) **VERFAHREN ZUM HERSTELLEN EINES KRAFTFAHRZEUG-FORMBAUTEILS MIT EINER INTEGRIERTEN LEITERBAHN UND KRAFTFAHRZEUG-FORMBAUTEIL**
METHOD FOR PRODUCING A MOULDED VEHICLE COMPONENT COMPRISING AN INTEGRATED CONDUCTOR STRIP AND MOULDED VEHICLE COMPONENT
PROCEDE DE FABRICATION D'UN COMPOSANT MOULE D'UN VEHICULE COMPORTANT UNE PISTE CONDUCTRICE INTEGREE ET COMPOSANT MOULE D'UN VEHICULE

(30) Priorität: 24.02.2001 DE 10109087
(43) Veröffentlichungstag der Anmeldung: 26.11.2003
(60) Teilanmeldung: 04015563.2
(73) Patentinhaber: Leoni AG, 90402 Nürnberg (DE)
(72) Erfinder: ZAHRADNIK, Franz, 91074 Herzogenaurach (DE); HARTMANN, Uli, 33098 Paderborn (DE); GÖTZ, Knuth, 95511 Mistelbach (DE); REICHINGER, Gerhard, 91126 Rednitzhembach (DE)
(74) Vertreter: Tergau & Pohl Patentanwälte
(86) Internationale Anmeldenummer: PCT/EP2002/001896
(87) Internationale Veröffentlichungsnummer: WO 2002/068245

(56) Entgegenhaltungen:
- EP-A- 0 089 221
- EP-A- 0 297 678
- DE-A- 1 923 028
- DE-A- 19 502 044
- DE-A- 19 900 175
- DE-B- 1 086 770
- DE-B- 1 107 743
- US-A- 3 330 695
- US-A- 5 032 737
- US-A- 5 281 765
- US-A- 6 032 357

## Beschreibung

Die Erfindung betrifft ein Verfahren zum Herstellen eines Kraftfahrzeug-Formbauteils, wie eine Tür, ein Türmodul, ein Halbzeug oder der Armaturenbereich sowie ein nach dem Verfahren hergestelltes Kraftfahrzeug-Formbauteil.

Im Kraftfahrzeug-Bereich, insbesondere im Pkw-Bereich, wird eine möglichst kurze Wiederbeschaffungsdauer, also eine möglichst kurze Zeitspanne zwischen der Bestellung eines Endkunden und der Auslieferung eines Kraftfahrzeugs vom Produktionsort, angestrebt. Hierzu ist es notwendig, dass die zum Produktionsort zugelieferten Komponenten einen hohen Vorfertigungsgrad aufweisen. Auf Seiten der Zulieferer bedeutet dies, dass innerhalb kürzester Zeit unterschiedlich konfigurierte Bauteile mit einer hohen Integrationsdichte, also mit unterschiedlichen Funktionen, hergestellt werden müssen.

Im Bordnetz-Bereich für die Kraftfahrzeug-Elektrik werden heute üblicherweise mehrere elektrische Leiter zu einem vorgefertigten Kabelsatz zusammengefügt.

Aus der WO 99/61282 ist zu entnehmen, einen Kabelsatz unmittelbar in ein Türmodul zu integrieren, so dass die in der Tür angeordneten elektrischen Komponenten nur noch über eine Steckverbindung mit dem restlichen Bordnetz verbunden werden müssen. Damit ist eine aufwändige Installation des Kabeisatzes im Türbereich beim Einbau der Tür an die Karosserie vermieden. Zur Verlegung des Kabelsatzes im Türmodul weist dieses eingearbeitete Nuten auf, in denen die einzelnen Leiter des Kabeisatzes verlegt werden. Dies hat den Nachteil, dass die Nuten vergleichsweise aufwendig in das Türmodul eingearbeitet werden müssen, und dass Änderungen am Verlauf des Kabeisatzes auch Änderungen an den Nuten erfordern. Wegen der großen Modellvielfalt im Kraftfahrzeug-Bereich im Hinblick auf die elektrischen Ausstattungsvarianten führt dies dazu, dass auf besondere Kundenwünsche nur wenig flexibel reagiert werden kann bzw. dass ein großer Aufwand zur Realisierung derartiger Kundenwünsche notwendig ist.

Aus der US 6,032,357 sowie aus der DE 199 00 175 A1 sind als Leitungsbahnen für ein Türmodul gedruckte Schaltungen zu entnehmen. Die Leitungsbahnen sind hierbei auf einem Träger aufgedruckt, welcher anschließend nach dem Aufdrucken der Leiterbahnen mit dem Türmodul beispielsweise durch Kleben befestigt wird.

Der Erfindung liegt die Aufgabe zugrunde, eine flexible und kostengünstige Herstellung eines Formbauteils für ein Kraftfahrzeug mit einer daran angebrachten Leiterbahn zu ermöglichen.

Die Aufgabe wird gemäß der Erfindung gelöst durch ein Verfahren mit den Merkmalen des Anspruchs 1. Danach ist vorgesehen, auf ein Kraftfahrzeug-Formbauteit eine Leiterbahn unmittelbar aufzubringen, so dass diese mit dem Formbauteit integral verbunden ist. Dabei
a) wird die Oberfläche des Formbauteils selektiv entsprechend einem vorgesehenen Verlauf der Leiterbahn behandelt, so dass die Oberfläche Bereiche unterschiedlicher Haftung aufweist,
b) im vorgesehen Verlauf der Leiterbahn wird eine Keimschicht aufgetragen und
c) auf die Keimschicht wird die Leiterbahn aufgebracht.

Leiterbahn im vorliegenden Sinne ist dabei insbesondere eine Leiterbahn eines Kabelsatzes eines Bordnetzes im Kraftfahrzeug-Bereich. Das Formbauteil kann eine beliebige Kraftfahrzeug-Komponente sein, die zur Verlegung eines Kabelsatzes oder zur Anordnung von elektrischen Komponenten vorgesehen ist. Das Formbauteil ist beispielsweise eine Tür, ein Türmodul, ein Halbzeug (Blech) oder auch der Armaturenbereich. Das Formbauteil kann aus beliebigem Material, beispielsweise Metall oder Kunststoff sein. Das Formbauteil wird im Folgenden auch als Trägerbauteil bezeichnet.

Dem Schritt a) liegt dabei die Überlegung zugrunde, dass auf beliebig gestalteten Oberflächen diskrete Leiterbahnstrukturen flexibel, schnell und ohne hohen Kostenaufwand erzeugt werden, ohne dass in das Formbauteit beispielsweise Nuten oder andere Kabetführungen angebracht werden müssen. Durch den Schritt a) wird also die gewünschte Leiterbahnstruktur festgelegt. Dem Schritt b) liegt die Überlegung zugrunde, dass die Keim- oder Haftvermittlerschicht für eine sichere Haftung der Leiterbahn auf dem Trägerbauteil sorgt. Die Reihenfolge der Schritte a) und b) kann auch vertauscht werden, d.h. es kann zunächst großflächig eine Keimschicht, beispielsweise durch Auftragen eines leitfähigen Pulvers, aufgetragen werden, die jedoch zunächst überall auf der Oberfläche gleichermaßen haftet. Anschließend wird beispielsweise durch eine selektive Wärmebehandlung die Oberfläche des Trägerbauteils lokal aufgeschmolzen, so dass das Keimschicht-Pulver in diesen Bereichen fest haftet. Für diese Variante besteht das Trägerbauteil aus Kunststoff oder weist vorzugsweise einen Überzug oder eine Oberfläche aus Kunststoff, wie z.B. einen Lack oder einen Kleber, auf.

Die vorzugsweise metallische Keimschicht kann auch als Haftvermittlerschicht zwischen der Oberfläche des Trägerbauteils und der Leiterbahn aufgefasst werden. Damit lassen sich auf Trägerbauteilen aus unterschiedlichsten Materialien sicher Leiterbahnmuster erzeugen, ohne dass die Gefahr eines Ablösens besteht. Die Leiterbahn wird also im Schritt c) mit guter Anbindung an das Trägerbauteil aufgebracht.

Durch dieses neuartige Verfahren lässt sich auf beliebig ausgebildeten und beliebig geformten Trägerbauteilen flexibel je nach der gewünschten Anforderung das gewünschte Leiterbahnmuster unmittelbar auf dem Trägerbauteil erzeugen. Ein manuelles Verlegen von einzelnen Kabeln oder Kabelsträngen ist nicht erforderlich. Vielmehr kann ein hoher Automatisierungsgrad erreicht werden. Durch das Verfahren kann prinzipiell das gesamte Bordnetz eines Kraftfahrzeugs schnell, flexibel und kostengünstig ausgebildet werden, so dass ein kabelfreies Bordnetz erhalten werden kann. Durch die unmittelbare Integration auf dem Trägerbauteil ohne abstehende Teile ist die aufgebrachte Leiterbahn zudem gut vor mechanischen Beschädigungen, beispielsweise durch Marderbiss, geschützt.

Beim Schritt nach a) können wahlweise die für die Leiterbahnstruktur vorgesehenen Bereiche haftend ausgebildet werden. Oder alternativ ― falls ein großflächig haftender Untergrund, beispielsweise eine entsprechende Lackschicht, vorliegt - kann die Hafteigenschaft der komplementären Bereiche, die nicht für das Leiterbahnmuster vorgesehen sind, reduziert werden.

Vorzugsweise wird die Leiterbahn mit einem strahlgebundenen thermisch-kinetischen Auftragsverfahren oder Spritzverfahren aufgebracht. Unter strahlgebundenen thermisch-kinetischen Auftragsverfahren werden allgemein derartige Auftragsverfahren verstanden, bei denen ein Teilchenstrom, nämlich das aufzubringende Material, insbesondere Kupferpartikel, mit kinetischer Energie und nach Wärmezufuhr auf das Trägerbauteil gerichtet wird. Ein derartiges Verfahren wird allgemein auch als thermisches Spritzen bezeichnet, wie es in der DIN 32530 aufgeführt ist. Für ein möglichst zielgerichtetes Aufbringen können Blenden, elektromagnetische Felder oder so genannte ummantelte Strömungen vorgesehen sein. Der Begriff thermisch ist dabei dahingehend zu verstehen, dass die Teilchen des Teilchenstroms insbesondere erweichen, anschmelzen oder schmelzen, oder dass sie zumindest so weit erwärmt werden, dass sie eine thermische Veränderung der Oberfläche des Trägerbauteils hervorrufen. Die thermische Veränderung kann in einer Reduzierung der Oberflächenhärte, einem Erweichen oder einem Anschmelzen der Oberfläche bestehen. Der Begriff kinetisch ist dahingehend zu verstehen, dass der Impuls der Teilchen ausreichend hoch ist, so dass sie beim Auftreffen auf die Oberfläche in diese ― gegebenfalls zuvor erweichte Oberfläche - zumindest teilweise eingepresst werden.

Als Auftragsverfahren eignet sich insbesondere das so genannte Flammspritzen. Bei diesem Spritzverfahren wird das aufzubringende Leiterbahnmaterial, insbesondere Kupfer, während des Spritzprozesses zumindest teilweise aufgeschmolzen. Aufgrund des Wärmeeintrags schmilzt die Keimschicht vorzugsweise zumindest teilweise an, so dass sich die Keimschicht und das Leiterbahnmaterial innig und vorzugsweise stoffschlüssig verbinden. Die Schichtdicke der Leiterbahn kann durch geeignete Wahl der Spritzparameter oder auch durch mehrmaliges Überstreichen im Hinblick auf eine ausreichend hohe elektrische Leitfähigkeit entsprechend dick eingestellt werden. Mit dem Flammspritzen ist ein sehr schnelles und wirtschaftliches Auftragen der Leiterbahn mit vergleichsweise geringem technischen Aufwand möglich.

Neben dem Flammspritzen eignet sich auch das so genannte Kaltgasspritzen. Dieses Verfahren ist auch unter dem Begriff Strahlplattieren bekannt. Bei dem Verfahren prallen Teilchen mit sehr hoher kinetischer Energie auf das Trägerbauteil auf. Die Teilchen werden dabei teilweise bis auf Schallgeschwindigkeit oder darüber beschleunigt. Der Durchmesser der Teilchen, beispielsweise Kupferpartikel, liegt beispielsweise im Bereich zwischen 10 und 100 µm. Mit dem Kaltgasspritzen ist ein Masseauftrag mit einer hohen Rate möglich. Aufgrund der hohen kinetischen Energie sind vergleichsweise niedrige Temperaturen ausreichend, so dass die Temperaturbelastung des Trägerbauteils sowie des Spritzwerkstoffs, also der Teilchen, gering ist. Insgesamt ist eine hohe Spritzrate und ein hoher Auftragungswirkungsgrad möglich und dicke Schichten aufbringbar.

Ein wesentlicher Vorteil in der Ausbildung der Leiterbahnstruktur mit Hilfe des thermisch-kinetischen Auftragsverfahrens, insbesondere des Flammspritzens, besteht in der hohen Flexibilität, da mit dem Spritzprozess beliebige Leiterbahnstrukturen auch auf komplexen Formbauteilen erzeugt werden können. Zudem kann die Leiterbahnstruktur zügig erzeugt werden. Weiterhin hat der Spritzprozess den Vorteil, dass eine selektive und insbesondere chemiefreie Behandlung des Trägerbauteils möglich ist. Für die selektive Behandlung wird der Strahl vorzugsweise durch Blenden, elektromagnetische Strahlen oder durch ummantelte Strömungen zielgerichtet geführt. Für ein möglichst schnelles Erzeugen einer komplexen Leiterbahnstruktur werden vorzugsweise mehrere Werkzeug- oder Spritzköpfe gleichzeitig nebeneinander in einer Rasteranordnung betrieben.

Bei dem Auftragsverfahren werden die Teilchen üblicherweise von einem Trägergas mitgetragen, welches bevorzugt ein Inertgas wie Stickstoff ist. Hierdurch ist die Gefahr einer unerwünschten Oxidation der Teilchen gering gehalten, so dass die erzeugte Leiterbahn eine gute Leitfähigkeit aufweist.

Zweckdienlicherweise werden dem Teilchenstrahl neben leitfähigen Teilchen zusätzlich nicht leitfähige Verunreinigungen, insbesondere Silizium, beigemischt. Durch diese Verunreinigungen, die bevorzugt im Bereich 0,01 ― 1,6 Gew% liegen, wird ohne Veränderung der mechanischen Eigenschaften die Leitfähigkeit der erzeugten Leiterbahnen günstig beeinflusst.

Alternativ zum thermisch-kinetischen Auftragsverfahren kann die Leiterbahn prinzipiell auch durch andere Verfahren auf die ausgebildete Keimschicht aufgebracht werden. Insbesondere kann das Trägerbauteil durch ein Schmelzbad gezogen werden, wobei nur an der Keimschicht das Material haften bleibt und die Leiterbahn ausgebildet wird. Zum Aufbringen aus der Schmelze kann das schmelzflüssige Material auch nach Art des Wellenlötens aufgebracht werden. Daneben kann die Leiterbahn auch durch Auftragen einer leitfähigen Paste, durch Aufbringen eines leitfähigen Pulvers oder durch einen Laminierprozess aufgebracht werden. Beim Aufbringen der Leiterbahn aus einem leitfähigen Pulver heraus ist im Hinblick auf eine ausreichende Leitfähigkeit eine möglichst dichte Anordnung der Pulverpartikel wichtig. Zur Verbesserung der Leitfähigkeit wird vorzugsweise nach dem Aufbringen des Pulvers die Leiterbahn erhitzt, so dass die einzelnen Partikel nach Art eines Sintervorgangs miteinander verbacken. Insbesondere wird hierzu durch die Leiterbahn ein hoher Strom geführt. Allen Verfahren ist gemeinsam, dass das aufgetragene leitfähige Material lediglich im Bereich der Leiterbahnstruktur aufgetragen wird, wodurch die gewünschte Leiterbahn ausgebildet wird.

In einer bevorzugten Ausbildung werden mehrere der Verfahrensschritte a) bis c) von einer Bearbeitungsvorrichtung ausgeführt, was ein schnelles und wirtschaftliches Erzeugen der Leiterbahnstruktur ermöglicht. Hierzu weist die Bearbeitungsvorrichtung beispielsweise eine Wärmequelle zur Veränderung der Hafteingenschaft der Oberfläche durch Wärmebehandlung auf. Zugleich ist in der Vorrichtung eine Zuführeinheit für Kupferpartikel zur Ausbildung der Keimschicht integriert. Als drittes kann zugleich noch ein Spritzkopf für das Erzeugen der Leiterbahn integriert sein. Alternativ kann mit dem Spritzkopf sowohl die Keimschicht als auch die Leiterbahn erzeugt werden.

Für die Veränderung der Hafteigenschaft nach Schritt a) stehen mehrere vorteilhafte Alternativen nach Anspruch 7 zur Verfügung. Gemäß einer bevorzugten Ausgestaltung wird das Trägerbauteil mit einem vernetzbaren Stoff beschichtet, dessen Hafteigenschaft durch anschließende Vernetzung verändert wird. Als vernetzbare Stoffe sind insbesondere Elastomere vorgesehen. Beispiele hierfür sind ein Kautschuklack oder Silikone. Bevorzugt wird Kautschuklack als das Oberflächenmaterial eingesetzt. Im unvernetzten Bereich bleibt der Kautschuklack für das Aufbringen der Keimschicht haftend.

Alternativ hierzu ist als Oberflächenmaterial vorzugsweise ein aushärtbarer Stoff wie ein Epoxidharz, Polyurethane oder Cyanacrylate vorgesehen. Zudem bieten sich auch keramische Stoffe an. Deren Vorteile liegen in ihrer hohen Temperaturbeständigkeit. Sie eignen sich daher insbesondere zur Verlegung einer Leiterbahn zu einem Sensor in einem temperaturbeanspruchten Bereich, beispielsweise in Brennraum- oder Bremsnähe.

In einer weiteren bevorzugten Ausbildung wird die Hafteigenschaft durch Aufbringen einer insbesondere chemisch aktiven Substanz auf das Oberflächenmaterial verändert. Diese chemisch aktive Substanz dient beispielsweise dazu, ein chemisch aktivierbares Oberflächenmaterial, beispielsweise einen geeigneten Kautschuklack, zu vernetzen. Alternativ kann auch vorgesehen sein, als chemisch aktive Substanz ein Lösemittel z.B. auf eine Kunststoffoberfäche aufzubringen. Die Kunststoffoberfläche ist beispielsweise eine auf einem metallischen oder keramischen Trägerbauteil aufgebrachte Lackschicht.

Die Veränderung der Hafteigenschaft erfolgt in einer weiteren bevorzugten Alternative durch Wärmebehandlung, insbesondere durch Wärme- oder elektromagnetische Strahlung. Insbesondere wird das Oberflächenmaterial laserbehandelt. Zur Erzeugung der Wärmestrahlung kann auch ein Halogenstrahler, vorzugsweise mit einer Leistung zwischen 50 und 70 Watt, herangezogen werden. Eine Fokussierung kann dabei durch Linsen oder Blenden erfolgen. Die gleichzeitige Verwendung mehrerer Strahler ist von Vorteil. Mit der Wärmebehandlung wird die Oberfläche, insbesondere Kunststoffoberfläche, des Trägerbauteils etwas erweicht. Auf diese erweichten Oberflächenbereiche wird dann zur Ausbildung der Keimschicht beispielsweise ein Kupferpulver aufgebracht. Mit der Bestrahlung ist ein sehr schnelles, flexibles Behandeln des Oberflächenmaterials mit einer hohen Ortsauflösung möglich. Alternativ zur Bestrahlung mit einer Strahlungsquelle kann der Wärmeeintrag auch durch eine Flamme oder mittels Heißluft erfolgen.

Die Hafteigenschaft kann auch in zweckdienlicher Weise durch unmittelbares selektives Aufbringen einer Haftschicht auf die Oberfläche verändert werden. Hierzu wird beispielsweise eine Lack- oder ein Klebschicht aufgetragen. Die Hafteigenschaft der Lackschicht kann dabei zusätzlich noch durch einen Wärmeeintrag beeinflusst werden. Dem selektiven Aufbringen liegt dabei die Überlegung zugrunde, das Trägermaterial nur bereichsweise im vorgesehenen Leiterbahnverlauf und nicht flächendeckend mit einer Lackschicht zu versehen. Dies führt zu Material- und Kosteneinsparungen. Hierbei kann vorgesehen sein, dass zugleich mit dem Auftrag der Haftschicht auch die Keimschicht nach Schritt b) erzeugt wird, beispielsweise indem in dem aufzutragenden Lack metallische Partikel enthalten sind, die als Haftvermittler für die Leiterbahn wirken.

Gemäß einer weiteren bevorzugten Variante wird zur Erzeugung der haftenden Leiterbahnstruktur das Oberflächenmaterial elektrostatisch aufgeladen. Auf die elektrostatisch aufgeladene Leiterbahnstruktur wird anschließend ein geeignetes Material, beispielsweise Graphitpulver, aufgetragen, wie dies beispielsweise aus dem Bereich des Laserdruckens bekannt ist.

Zur Ausbildung der Hafteigenschaft ist es ― je nach Beschaffenheit des Trägerbauteils ― von Vorteil, das Trägerbauteil in einem von der gewünschten Leiterbahnstruktur unabhängigen Bereich insbesondere großflächig mit einem speziellen Oberfiächenmaterial zu versehen, dessen Hafteigenschaft dann selektiv verändert wird. Dieses Oberflächenmaterial ist beispielsweise durch einen Beschichtungsprozess aufgetragen. Durch die großflächige Verteilung des Oberflächenmaterials, insbesondere über das gesamte Trägerbauteil hinweg, besteht die Möglichkeit, beliebige Leiterbahnstrukturen flexibel und kostengünstig zu erzeugen. Hierzu wird lediglich die Hafteigenschaft des Oberflächenmaterials im Bereich des gewünschten Leiterbahnverlaufs verändert. Die Festlegung des Verlaufs der Leiterbahn erfolgt also erst unmittelbar vor dem Aufbringen der eigentlichen Leiterbahn und bedarf keiner aufwändigen Eingriffe, beispielsweise durch das Einarbeiten von Nuten in das Trägerbauteil.

Die Keimschicht wird vorzugsweise nach einer der im Anspruch 8 aufgeführten Alternativen aufgebracht. Die Keimschicht wird auch als Vermittlerschicht bezeichnet. Sie sorgt für eine gute Anbindung der Leiterbahn am Trägerbauteil
Insbesondere ist vorgesehen, ein Pulver, insbesondere ein Kupferpulver, auf die Oberfläche des Trägerbauteils aufzubringen. Dies erfolgt beispielsweise durch ein großflächiges Aufbringen mit anschließendem Wegblasen von den nicht haftenden Oberflächenbereichen. Das Pulver kann auch zielgerichtet durch ein Röhrchen aufgetragen werden, welches beispielsweise unmittelbar hinter der Strahlungsquelle (Halogenstrahler) angeordnet ist, mit der die Hafteigenschaft verändert wird. Weiterhin kann das Trägerbauteil auch durch ein Pulverbad gezogen werden. Ein Anpressen des Pulvers erfolgt dabei beispielsweise durch aktives Umwälzen des Pulvers im Pulverbad oder durch Aufschütten des Pulvers auf das Trägerbauteil. Als weitere bevorzugte Altemative ist vorgesehen, eine metallischen Suspension auf das Trägerbauteil aufzubringen. Die metallische Suspension umfasst in einem Fluid verteilte Metallteilchen. Das Fluid verdunstet oder wird vom Material des Trägerbauteils aufgesogen und die Metallteilchen bleiben selektiv haften. Das Auftragen erfolgt beispielsweise mit Düsen oder mit Stiften, wie sie beispielsweise der Art nach bei Plottern eingesetzt werden.

Die Keimschicht ist vorzugsweise selbst bereits elektrisch leitfähig. Prinzipiell kann auch eine nicht-metallische und nicht leitfähige Keimschicht aufgetragen werden, sofern sie als Haftvermittlerschicht für das nachfolgende Aufbringen der Leiterbahn geeignet ist.

Bevorzugt weist die Keimschicht im vorgesehenen Verlauf der Leiterbahn Unterbrechungen auf. Die Keimschicht wird also nicht über den gesamten Bereich der Leiterbahn aufgetragen, sondern nur bereichsweise. Die Keimschicht kann dabei Schraffurcharakter, Rautencharakter, Waben- oder Punktcharakter haben. Im Bereich der Unterbrechungen findet keine Anbindung der Leiterbahn an das Trägerbauteil statt. Diese nicht haftenden Bereiche werden von der Leiterbahn überbrückt. Diese Ausgestaltung dient zum Längen- oder Toleranzausgleich, so dass z.B. aufgrund von unterschiedlichen thermischen Ausdehnungskoeffizienten bedingte Längenunterschiede zwischen der Leiterbahn und dem Trägerbauteil kompensiert werden, ohne dass die Leiterbahn beschädigt wird. Insgesamt wird durch diese Maßnahme die Leiterbahnstruktur elastisch.

Vorzugsweise wird die Leiterbahn zumindest teilweise auf einer Ausgleichsschicht aufgebracht, die mit dem Trägerbauteil schwimmend ― also nur lose verbunden ist. Die schwimmende Lagerung der Ausgleichsschicht mit der darauf angebrachten Leiterbahn dient zum Toleranzausgleich bei Auftreten von Schub- oder Scherspannungen im Trägerbauteil oder auch in einem Übergangsbereich zwischen zwei Trägerbauteilen. Durch die schwimmende Lagerung der Ausgleichsschicht auf dem Trägerbauteil werden eventuell auftretende Spannungen nicht oder in einem nur geringen Maße auf die Leiterbahn übertragen, so dass diese nur gering belastet ist und unbeschädigt bleibt. Die Ausgleichsschicht ist beispielsweise gebildet durch einen geeigneten Kautschuklack, der sich nach dem Vernetzen vom Trägerbauteil ablöst. Angrenzend an die Ausgleichsschicht ist die Leiterbahn auf eine fest mit dem Trägerbauteil verbunden Schicht, beispielsweise eine Epoxidharzschicht, oder auch unmittelbar auf dem Trägerbauteil angebracht.

Zur Verbesserung der Leitfähigkeit ist gemäß einer vorteilhaften Variante vorgesehen, die Materialstruktur der bereits aufgebrachten Leiterbahn zu verändern. Hierzu wird die Leiterbahn beispielsweise thermisch, insbesondere mit dem Laser, oder auch druckbehandelt.

Zweckdienlicherweise wird auf die aufgebrachte Leiterbahn eine weitere Beschichtung aufgetragen. Diese dient wahlweise oder in Kombination zur Erhöhung der Leitfähigkeit oder als Schutzschicht gegen Korrosion und/oder als Isolationsschutzschicht. Als Korrosionsschutzschicht wird beispielsweise ein PU-Material oder auch Kautschuk auf die Leiterbahn aufgebracht. Die Leiterbahn selbst kann aber bereits auch selber aus einem korrosionsbeständigen Material, beispielsweise einer Zinn-Bronze-Legierung bestehen. Dies hat dann den Vorteil, dass die Leiterbahn unmittelbar an beliebigen Positionen kontaktierbar ist.

Zweckdienlicherweise wird insbesondere nach dem Aufbringen des leitfähigen Materials überschüssig aufgebrachtes Material und/oder Verunreinigungen durch einen Reinigungsprozess entfernt. Hierzu wird das Trägerbauteil beispielsweise mit einer Flüssigkeit oder auch mit Druckluft in einem Spülprozess behandelt. Alternativ hierzu bieten sich mechanische Reinigungsverfahren wie Bürsten oder auch eine Laserbehandlung an.

Um eine sichere und dauerhafte Verbindung der Leiterbahn mit dem Trägerbauteil zu erreichen, wird die Haftung der Leiterbahn durch einen geeigneten Fixierprozess erhöht. Bei der Ausführungsvariante mit dem Kautschuklack geschieht dies beispielsweise dadurch, dass der zunächst unvernetzte Leiterbahnbereich durch Vulkanisieren vernetzt wird. Vorzugsweise wird dabei das Vulkanisieren durch Wärmebehandlung erreicht, die gleichzeitig mit dem Auftragen der leitfähigen Schicht, beispielsweise durch Aufbringen eines heißen Kupferpulvers, erzielt wird.

Um eine möglichst hohe Funktionsdichte zu erzielen, wird die Leiterbahn oder werden mehrere Leiterbahnen derart aufgebracht, dass ein elektrisches Funktionsbauteil erzeugt wird. Dies ist beispielsweise ein Kondensator, eine Spule oder auch ein Widerstand. Hierzu werden die Leiterbahnen geeignet geometrisch ausgebildet. Beispielsweise wird zur Einstellung eines bestimmten Widerstands der Leiterbahnquerschnitt variiert. Zur Ausbildung eines Kondensators mit einer geeigneten Kapazität wird eine entsprechende Kondensatorfläche durch die Leiterbahn oder durch einen bestimmten Teilbereich der Leiterbahn vorgegeben, und zur Erzeugung einer Spule wird die Leiterbahn geeignet geführt. Die Leiterbahnen können alternativ auch als Abschirmung ausgebildet sein. Das Funktionsbauteil ist bevorzugt weiterhin als ein sicherheitsrelevanter Sensor ausgebildet. Beispielsweise werden Kapazitätsänderungen eines durch die Leiterbahnen gebildeten Kondensators im Bereich eines Karosserie-Außenblechs als Indiz für eine Verformung herangezogen und es wird die Auslösung eines Airbags initiiert.

In einer besonders bevorzugten Ausgestaltung werden mehrere Leiterbahnen in Schichten übereinander angeordnet. Hierdurch wird einerseits der Platzbedarf in der Fläche gering gehalten und gleichzeitig lassen sich elektrische Funktionsbauteile, wie beispielsweise Kondensatoren verwirklichen.

Bei komplexen Leiterbahnmustem ist dabei darauf zu achten, dass insbesondere durch eine geeignete Führung der Leiterbahnen, also durch geometrische Maßnahmen, die Gefahr von Lichtbögen vermieden wird. Die Gefahr des Auftretens von Lichtbögen ist insbesondere bei so genannten 42V-Bordnetzen im Kraftfahrzeugbereich gegeben. Hierbei sind bevorzugt insbesondere folgende Maßnahmen vorgesehen:
- Die Leiterbahnen weisen speziell in kritischen Bereichen einen genügenden Abstand zueinander auf. Sie werden also insbesondere in Bereichen mit hoher Lichtbogenneigung, beispielsweise in Kontaktbereichen, mit einem weiten Rastermaß und in ungefährdeten Bereichen mit einem engen Rastermaß erzeugt.
- Zwischen Leiterbahnen mit Potentialunterschieden wird zumindest eine zusätzliche Leiterbahn angeordnet, die als Sensor beispielsweise für das Auftreten einer erhöhten Temperatur und damit eines Lichtbogens dient.
- Die zwischen Leiterbahnen mit Potentialunterschieden angeordnete Leiterbahn ist Teil eines Abschaltkreises, so dass bei Auftreten eines Lichtbogens die betroffenen Leiterbahnen von der Spannungsversorgung getrennt werden können.
- Bei einem dreidimensionalen Multilayeraufbau, bei dem mehrere Leiterbahnen übereinander angeordnet werden, wird nicht nur flächig sondern auch räumlich ein geeignetes Rastermaß für die Leiterbahnen vorgesehen. Dies geschieht insbesondere durch eine gegeneinander versetzte Anordnung der Leiterbahnen, so dass die Leiterbahn der oberen Ebene über einem Isolationsstreifen zwischen zwei Leiterbahnen der darunter liegenden Ebene angeordnet ist.
- Kontaktstellen werden vorzugsweise in Zickzack- oder Sägezahnanordnung vorgesehen, so dass die Kriechstrecke zwischen den Kontaktstellen möglichst groß und gleichzeitig das Raster der Kontaktstellen (Anschlussraster) möglichst klein gehalten wird.

In einer vorteilhaften Ausbildung werden schichtweise angeordnete großflächige leitfähige Ebenen ausgebildet, die Teil eines elektrischen Bordnetzes sind und unterschiedliche Funktionen für das Bordnetz wahrnehmen. Die leitfähigen Ebenen sind übereinander angeordnet und erstrecken sich parallel zum Trä-gerbauteil. Dieser Ausführungsvariante liegt die ldee zugrunde, durch großflächige leitfähige Ebenen eine ortsunabhängige Kontaktierung einer elektrischen Komponente zu ermöglichen. Von den einzelnen leitfähigen Ebenen kann nahezu an beliebigen Positionen beispielsweise die Versorgungsspannung für die elektrische Komponente abgegriffen werden. Die einzelnen leitfähigen Ebenen übernehmen dabei unterschiedliche Funktionen für das Bordnetz. Insbesondere weisen zwei Ebenen unterschiedliche Potentiale auf und weitere Ebenen dienen als Datenbusleitung.

Werden ausschließlich leitfähige Ebenen auf dem Trägerbauteil angeordnet, so definieren diese jeweils eine Leiterbahn und die Leiterbahnstruktur ist entsprechend großflächig als Ebene ausgebildet. Zudem besteht die Möglichkeit, die schichtweise angeordneten leitfähigen Ebenen mit diskreten, also nicht großflächigen, einzelnen Leiterbahnen zu kombinieren. Die leitfähigen Ebenen sind vorzugsweise ― ebenso wie die diskreten Leiterbahnen ― als elektrische Funktionsbauteile, beispielsweise Kondensatoren, oder Sensoren ausgebildet.

Um eine einfache Verbindung der Leiterbahn des Formbauteils mit dem übrigen Bordnetz, beispielsweise über eine Steckverbindung zu ermöglichen, ist gemäß einer bevorzugten Weiterbildung vorgesehen, dass die Leiterbahn nicht vollständig mit dem Trägerbauteil verbunden ist, sondern in einem Teilbereich von diesem abtrennbar oder abhebbar ist. Dies wird vorzugsweise dadurch erreicht, dass unter der Leiterbahn ein Trennelement oder eine Trennschicht aufgebracht ist. Alternativ hierzu wird ein Teilstück des Leiterbahnbereichs derart behandelt, dass in diesem Teilbereich die Haftung mit dem Trägerbauteil aufgehoben wird. Dies geschieht beispielsweise durch thermische Behandlung des Kautschuklacks. Um die teilweise Abtrennbarkeit zu ermöglichen ist weiterhin bevorzugt vorgesehen, unterschiedliche Oberflächenmaterialien nebeneinander im Leiterbahnbereich anzuordnen, wobei eines der Oberflächenmaterialien sich - beispielsweise nach geeigneter Behandlung - vom Trägerbauteil abnehmen lässt. In einer weiteren bevorzugten Ausgestaltung wird vor dem Aufbringen der Leiterbahn an das Trägerbauteil eine Verlängerung angelegt, auf die sich die Leiterbahn erstreckt,. so dass eine Art Kabelschwanz ausgebildet wird. Dieser Kabelschwanz dient beispielsweise zur Durchführung des Kabelsatzes aus dem Türbereich zur übrigen Karosserie des Kraftfahrzeugs.

Für eine einfache elektrische Kontaktierung eines Anschlussleiters wird vorzugsweise dieser mit einem Leiterende auf den Bereich der Leiterbahnstruktur gelegt und durch das anschließende Aufbringen der Leiterbahn mit dieser elektrisch leitend verbunden. Dabei wird zwischen dem Anschlussleiter und der Leiterbahn eine unmittelbare stoffliche Verbindung geschaffen, da der Anschlussteiter mit der Leiterbahn "beschichtet" wird. Ein nachfolgender Lötvorgang ist nicht notwendig. Erfolgt das Auftragen der Leiterbahn unter Wärmeeinftuss, so braucht das Ende des Anschlussleiters nicht abisoliert zu sein. Die Isolation wird vielmehr beim Aufbringen der Leiterbahn zerstört.

Für eine sichere Kontaktierung werden dabei die Leiterenden der Anschlussleiter für möglichst große Verbindungs- und Kontaktflächen geeignet geformt. Dies erfolgt beispielsweise durch Abschrägen, durch Ausbilden einer Schalbenschwanz- einer Dreiecks- oder einer Zickzackform. Die Leiterenden sind dabei zweckdienlicherweise angefasst oder geschäftet. Alternativ oder zusätzlich werden die Leiterenden bevorzugt mit Ausnehmungen oder Löchern, z.B. durch Ausstanzen, versehen. Generell besteht die Möglichkeit, mit dem Auftragsverfahren für die Leiterbahnen zwei herkömmliche Leiter miteinander zu kontaktieren, deren Leiterenden hierzu vorzugsweise geeignet geformt sind.

Zur Erzeugung eines Kontaktsteckers ist vorzugsweise vorgesehen, dass auf das Trägerbauteil ein Steckerformteil aufgebracht wird, das anschließend zumindest teilweise mit einem Teilstück der Leiterbahn überzogen oder beschichtet wird. Das Steckerformteil ist als ein Einlegeteil aus Metall oder Kunststoff ausgestaltet, welches beispielsweise die Kontur eines Steckerstifts oder einer Steckerbuchse aufweist. Diese Kontur ist mit der Leiterbahn überzogen. Zur Kontaktierung der Leiterbahn braucht dann nur noch ein entsprechend ausgestalteter Gegenstecker auf diesen Kontaktstekker aufgebracht werden.

Allgemein lassen sich auf diese Weise Stecksysteme verwirklichen, bei denen die Form, Orientierung und das Rastermaß der einzelnen Kontaktstecker durch entsprechende Gestaltung des Steckerformteils nahezu beliebig gewählt werden können. Dadurch lassen sich insbesondere auch verwechslungssichere und/oder selbstverriegelnde Anschlüsse sowie Kodierungen verwirklichen.

Die unmittelbare stoffliche Kontaktierung der Leiterbahn bei ihrem Auftragen bietet sich auch bei der Kontaktierung von Bauelement- oder Schaltungsträgem untereinander oder zur Kontaktierung von Anschlüssen zu elektrischen Geräten, wie beispielsweise Motoren, Lautsprecher und dergleichen an. Insbesondere ist dabei vorgesehen, dass die Leiterbahn mit dem Schaltungsträger, beispielsweise eine Leiterplatte, oder einem Schaltungsträgerverbund kontaktiert wird. Hierzu wird in den Schaltungsträger bzw. in den Schaltungsträgerverbund ein Kontaktelement, beispielsweise ein Kontaktstift, eingebracht und die Leiterbahn wird mit diesem Kontaktstift kontaktiert. Beim Schaltungsträgerverbund werden die einzelnen Schaltungsträger über den Kontaktstift miteinander kontaktiert. Der Kontaktstift ist dabei entweder durchgehend leitfähig ausgebildet oder weist isolierte Bereiche auf und kann auch nach Art einer Buchse ausgebildet sein. Anstelle des Kontaktstifts kann auch eine Kontaktbuchse oder es können Kontaktplatten verwendet werden, die gegeneinander gepresst werden.

Alternativ zur Kontaktierung beim Auftragen der Leiterbahn kann die Kontaktierung mit dem Kontaktstift auch durch ein Anpressen gegen die erzeugte Leiterbahn oder durch Ausbildung eines Schneidklemmkontakts oder sonstiger Kontakte erreicht werden.

In einer bevorzugten Ausgestaltung wird ein elektrisches Bauelement durch die mit dem strahlgebundenen Auftragsverfahren erzeugte Leiterbahn kontaktiert. Das Bauelement ist dabei beispielsweise auf einer Leiterplatte angeordnet. Durch diese Maßnahme können die heute üblicherweise eingesetzten Löt- oder Leitklebeprozesse zur Kontaktierung von Bauelementen ersetzt werden.

Im Kraftfahrzeugbereich besteht oftmals die Notwendigkeit, eine elektrische Leitung durch ein Bauteil, beispielsweise ein Türblech, hindurchzuführen, um die Leitung von der Tür in den Fahrgastinnenraum oder in den Motorraum zu einer Steuereinheit zu führen. Für eine einfache Durchführung der Leiterbahnen ist zweckdienlicherweise vorgesehen, dass durch das Bauteil ein Kontaktelement geführt ist und dass die Leiterbahn beidseitig mit dem Kontaktelement kontaktiert wird. Die Leiterbahn wird dabei zweckdienlicherweise wiederum unmittelbar beim Auftragen stoffschlüssig mit dem Kontaktelement kontaktiert.

Da das Bauteil oftmals einen Nass- von einem Trockenbereich trennt, wird das Kontaktelement in zweckdienlicher Weise dichtend durch das Bauteil geführt. Das Kontaktelement wird hierzu beispielsweise als Metallniet ausgeführt und in ein nicht leitendes Bauteil dichtend eingepresst. Durch diese Maßnahme entfällt die Notwendigkeit der Anordnung einer Tülle, wie sie herkömmlich bei Leitungsdurchführungen durch derartige Bauteile vorgesehen sind. Ist das Bauteil leitfähig und insbesondere metallisch, so ist das Kontaktelement vorzugsweise mit einer Isolationsschicht oder beispielsweise einer Gummitülle umgeben.

Um auch bei Formteilen mit komplexer Geometrie ein einfaches Aufbringen der Leiterbahn zu ermöglichen, ist in einer besonders vorteilhaften Ausgestaltung vorgesehen, zunächst die Leiterbahn auf das Trägerbauteil aufzubringen und dieses anschließend durch einen Umformprozess, beispielsweise durch Tiefziehen, in die gewünschte Endform des Formbauteils überzuführen. Das Trägerbauteil ist also vorzugsweise als ein Halbzeug ausgebildet, welches entweder vollständig planar oder bereits vorkonturiert ausgebildet ist. Durch das Aufbringen der Leiterbahn vor einem Umformprozess kann das beschriebene Verfahren in einfacher Weise beispielsweise auch im Kotflügelbereich oder in anderen Bereichen mit engen Radien angewandt werden.

Zweckdienlicherweise wird dabei die Leiterbahn im Umformbereich des Trägerbauteils derart dimensioniert, dass die Leiterbahn nach dem Umformen die gewünschten elektrischen Eigenschaften aufweist. Beispielsweise wird die Leiterbahn im Umformbereich mit einer größeren Dicke als im restlichen Bereich aufgebracht. Damit wird beim Umformen, beispielsweise beim Tiefziehen, ein Reißen der Leiterbahn verhindert und eine ausreichende Leiterbahnstärke bei der Endform gewährleistet. Je nach Anwendungsfall wird die Schichtdicke zweckdienlich ausgelegt. Im Kraftfahrzeug-Bereich werden Schichtdicken typischerweise zwischen 20µm und 1mm aufgetragen.

In einer zweckdienlichen Ausgestaltung wird die Leiterbahn auf der Oberfläche eines strangartigen Formbauteils, wie beispielsweise ein elektrisches Kabel, ein Schlauch oder ein Rohr aufgebracht. Dadurch bieten sich viele Gestaltungsmöglichkeiten für üblich strangartige Formbauteile an, und diese Formbauteile können mit einer zusätzlichen Funktion versehen werden.
Beispielsweise wird die Außenoberfläche eines elektrischen Kabels, insbesondere ein umschäumtes Kabel vollständig mit der Leiterbahn beschichtet, so dass durch die Leiterbahn eine Abschirmung gegeben ist. Hierbei wird die Beschichtung vorzugsweise durch mehrere nebeneinander angeordnete Spritzdüsen aufgetragen.

Alternativ hierzu ist vorzugsweise die Ausbildung von mehreren parallel nebeneinander geführten diskreten Leiterbahnen vorgesehen. Diese können auch an der Innenoberfläche eines Schlauchs oder eines Rohres angeordnet werden. Hierzu wird beispielsweise beim Extrusionsvorgang eines Kunststoffschlauches mit einer geeigneten Spritzdüse die Leiterbahn auf der Innenoberfläche aufgetragen. Die Anordnung von Leiterbahnen auf der Innenoberfläche eines Rohres bietet sich beispielsweise bei Leerrohren für die Hausinstallationstechnik an, so dass über die Leiterbahn des Leerrohrs zugleich auch eine elektrische Verbindung geschaffen ist.

Für ein wirtschaftliches und kostengünstiges Herstellen des Formbauteils mit der integrierten Leiterbahn ist es allgemein von Vorteil, den Materialbedarf möglichst gering zu halten. Dies wird insbesondere durch folgende Maßnahmen erreicht:
- Das Rastermaß der Keimschichten für mehrere Leiterbahnen wird eng gewählt, um das Verhältnis der Fläche der Leiterbahnen zu der beim Spritzvorgang überstrichenen Fläche groß zu wählen.
- Die Leiterbahnen werden breit und niedrig ausgestaltet.
- Die Leiterbahnen werden vorzugsweise in Korridoren zusammengefasst, deren Breite im Wesentlichen der Breite des Strahls beim Spritzprozess entspricht, bzw. die Breite des Strahls wird an die Breite des Korridors angepasst. Hierzu wird beispielsweise zum Zweck der Fokussierung der Teilchenstrahl durch einen Umhüllungsstrahl gebündelt. Diese Maßnahme dient zugleich zur Schalldämmung
- Sofern für den Spritzvorgang mehrere Düsen oder Spritzköpfe eingesetzt werden, sind diese in geeigneter Weise angeordnet und insbesondere einzeln zu- und abschaltbar.
- Überschüssig aufgebrachtes Material, insbesondere Kupferpulver, wird durch einen Reinigungsprozess entfernt und zur Wiederverwertung einer Aufbereitung zugeführt.
- Um den unerwünschten Oxidanteil im Kupfer gering zu halten, wird die Umgebung beim Spritzprozess, beispielsweise ein Umhüllungsstrahl oder ein Transportstrahl, durch ein inertes Gas wie Stickstoff gebildet.

Die Aufgabe wird weiterhin gelöst durch ein Kraftahrzeug-Formbauteil mit einer Leiterbahn, die mit dem beschriebenen Verfahren auf das Formbauteil aufgebracht und mit diesem integral verbunden ist. Die im Hinblick auf das Verfahren aufgeführten Vorteile und bevorzugten Ausgestaltungen sind sinngemäß auch auf das Formbauteil zu übertragen.

Ausführungsbeispiele der Erfindung werden im Folgenden anhand der Zeichnung näher erläutert. Es zeigen jeweils in schematischen Darstellungen:
- Fig. 1A-C: eine schematische Darstellung der Verfahrensschritte zum Aufbringen einer Leiterbahn auf ein Trägerbauteil,
- Fig. 2: eine stark vereinfachte Darstellung eines Mehrschichtaufbaus eines Formbauteils nach Art einer Explosionsdarstellung,
- Fig. 3: mehrere Zwischenstufen beim Herstellungsprozess eines Formbauteils mit integrierten Leiterbahnen,
- Fig. 4: mehrere Zwischenstufen beim Herstellungsprozess eines Formbauteils mit integrierten Leiterbahnen in einem Mehrschichtaufbau,
- Fig. 5A: einen Mehrschichtaufbau mit einer Anzahl von übereinander angeordneten leitfähigen Ebenen mit Kontaktierungsfenstern für Kontaktierungsstifte,
- Fig. 5B: die zu den Kontaktierungsfenstern nach Fig. 5A korrespondierenden Kontaktierungsstifte,
- Fig. 6A: einen Mehrschichtaufbau mit mehreren leitfähigen Ebenen mit einem zugeordneten Kontaktstab,
- Fig. 6B: einen Kontaktstab in einer vergrößerten Darstellung,
- Fig. 7A: eine Aufsicht auf ein Formbauteil mit einer Anzahl von integrierten Leiterbahnen und mit zwei integrierten Kontaktsteckern,
- Fig. 7B: eine Schnittansicht durch das Formbauteil nach Fig. 7A gemäß der Schnittlinie 7B-7B,
- Fig. 8A: den Mehrschichtaufbau gemäß Fig. 2 mit Anschlussleitem, die mit den leitfähigen Ebenen bzw. mit einer Leiterbahn kontaktiert sind,
- Fig. 8B: eine vergrößerte Darstellung des Kontaktbereichs eines Anschlussleiters nach Fig. 8A,
- Fig. 9A: eine ausschnittsweise Schnittdarstellung durch ein Formbauteil mit integrierter Leiterbahn vor einem Umformprozess,
- Fig. 9B: das Formbauteil nach Fig. 9A nach einem Umformprozess,
- Fig. 10: eine stark vereinfachte Darstellung einer Kraftfahrzeug-Tür als Formbauteil mit diskreten Leiterbahnen,
- Fig. 11: eine stark vereinfachte Darstellung einer Kraftfahrzeug-Tür als Formbauteil mit großflächigen leitfähigen Ebenen,
- Fig. 12: eine schematische Darstellung mehrerer parallel betriebener Werkzeugköpfe eines Spritzverfahrens,
- Fig. 13: einen aus zwei Schaltungsträgern bestehender Schattungsträgerverbund, die über Kontaktstifte miteinander kontaktiert sind,
- Fig. 14: ein Bauteil mit durchgeführten Kontaktelementen, die beidseitig von Leiterbahnen kontaktiert sind,
- Fig. 15: zwei aneinander angrenzende Formbauteile mit einer Ausgleichsschicht, die den Stoßbereich der beiden Formbauteile überdeckt.

In den Figuren sind gleich wirkende Teile mit den gleichen Bezugszeichen versehen.

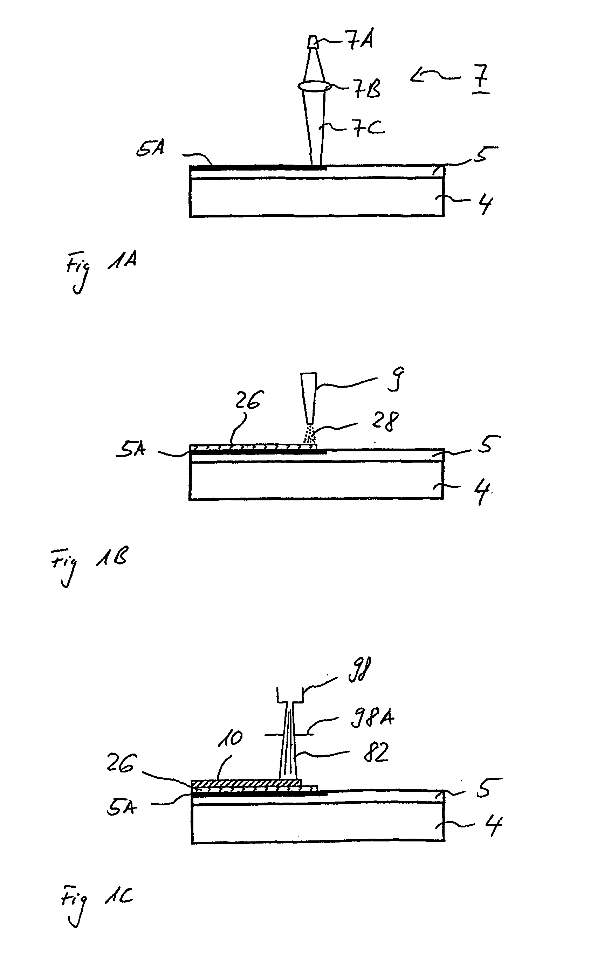

Anhand der Figuren 1A bis 1C werden zunächst die grundlegenden Schritte beim Erzeugen einer Leiterbahn 10 auf einem Trägerbauteil 4 beispielhaft dargelegt. Das Trägerbauteil 4 weist eine Oberflächenschicht 5 auf, die je nach dem Material des Trägerbauteils 4 und dessen Eignung zur Ausbildung eines Haftbereichs 5A entweder unmittelbar die Oberfläche des Trägerbauteils 4 ist oder in einem extra Verfahrensschritt als eigenständige Oberflächenschicht aufgebracht wurde. Beispielsweise ist die Oberfiächenschicht 5 eine Lackschicht. Im ersten Schritt gemäß Fig. 1A wird die Oberflächenschicht 5 selektiv behandelt, so dass im behandelten Bereich die Hafteigenschaften der Oberflächenschicht verändert werden und der Haftbereich 5A ausgebildet wird. Hierzu ist insbesondere ein Bestrahlungssystem 7 umfassend eine Strahlungsquelle 7A sowie eine Linse 7B zur Fokussierung des Strahlengangs 7C vorgesehen. Die Strahlungsquelle 7A ist ein Laser oder eine Halogenlampe. Über die Strahlungsquelle erfolgt ein Wärmeeintrag und ein Anschmelzen der Oberflächenschicht 5A.

Im zweiten Schritt gemäß Fig. 1B wird auf den Haftbereich 5A mit Hilfe eines Zuführrohres 9 insbesondere ein Kupfer-Pulver 28 aufgebracht und bleibt dort haften. Das aufgebrachte Pulver 28 dient als Keimschicht 26 für die im nachfolgenden Schritt (Fig. 1C) aufzubringende Leiterbahn 10. Die Keimschicht 26 dient als Haftvermittlerschicht für eine gute Anbindung der Leiterbahn 10 auf dem Trägerbauteil 4. Im Folgenden wird die Keimschicht 26 daher als Vermittlerschicht bezeichnet. Die ersten beiden Schritte können auch vertauscht werden, so dass zunächst das Pulver 28 aufgetragen und erst anschließend die Oberflächenschicht 5 angeschmolzen wird. Hierbei kann durch den Wärmeeintrag zugleich ein vorteilhaftes Verbacken oder Aufschmelzen und inniges Verbinden der Pulverteilchen erfolgen.

Im dritten Schritt wird dann die Leiterbahn 10 durch ein Spritzverfahren, insbesondere durch das Flammspritzen aufgebracht. Beim Flammspritzen wird in einer Düse 98 eines Spritzkopfes das aufzutragende Material, insbesondere Kupfer, erhitzt und zumindest teilweise an- oder aufgeschmolzen. Das Kupfer wird dem Spritzkopf dabei insbesondere als Pulver zugeführt, dessen Korngröße einen weiten Bereich von etwa 5µm bis in den mm-Bereich überstreichen kann. Die Geschwindigkeit der Teilchen liegt im Bereich von m/s und kann ― insbesondere beim Kaltgasspritzen ― Schallgeschwindigkeit erreichen. Die Teilchen werden dabei als ein von einem inerten Trägergas getragener Teilchenstrahl 82 auf das Trägerbauteil 4 aufgespritzt. Zur Fokussierung des Teilchenstrahls 82 ist eine Blende 98A vorgesehen. Zur Erzeugung der Leiterbahn 10 wird der Spritzkopf relativ zum Trägerbauteil 4 verschoben; wobei hohe Verfahrgeschwindigkeiten im Bereich von einigen m/s (z.B. etwa 2-10 m/s) und darüber erreichbar sind.

Das Flammspritzen hat den wesentlichen Vorteil, dass mit ihm ein sehr schnelles und insbesondere automatisierbares Auftragen einer komplexen Leiterbahnstruktur auf dem Trägerbauteil 4 ermöglicht ist. Dadurch kann ein aufwändiges manuelles Verlegen von einzelnen Kabeln bei einem Kraftfahrzeug-Bordnetz ersetzt werden. Zudem kann das Trägerbauteil 4 nahezu beliebige Ausgestaltungen aufweisen. Das Flammspritzen eignet sich auch zum Erzeugen der Keimschicht.

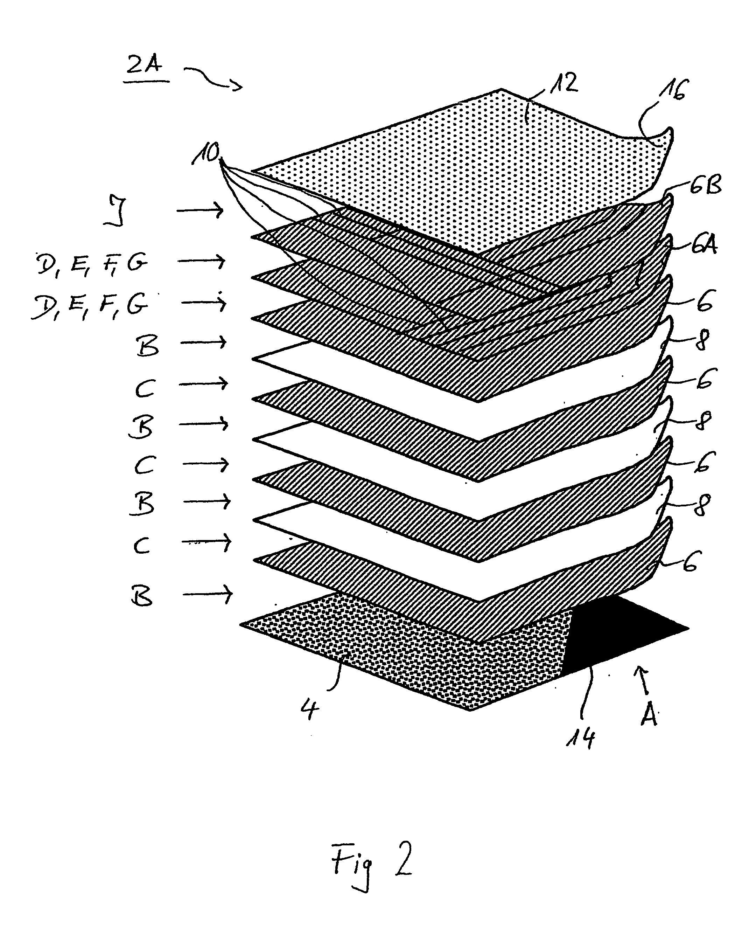

In den Figuren 2 bis 6 sind unterschiedliche Varianten eines komplex ausgebildeten Formbauteils mit Trägerbauteilen 4 und die Erzeugung der Leiterbahn dargestellt. Das Herstellen der Formbauteile mit den integrierten Leiterbahnen erfolgt in der Regel in mehreren Verfahrensschritten. Der Herstellungsprozess lässt sich dabei in folgende Grundverfahrensschritte unterteilen, die teilweise, alternativ oder in Kombination durchgeführt werden:
- Verfahrensschritt A:: vorbereitende Maßnahmen zur Erzeugung eines losen Teilbereichs der Leiterbahn;
- Verfahrensschritt B:: Aufbringen einer Isolationsschicht;
- Verfahrensschritt C:: Aufbringen einer leitfähigen Ebene;
- Verfahrensschritt D:: Aufbringen eines Oberftächenmateriats;
- Verfahrensschritt E:: Behandeln des Oberflächenmaterials zur Veränderung der Hafteigenschaft;
- Verfahrensschritt F:: Aufbringen einer Vermittlerschicht;
- Verfahrensschritt G:: Aufbringen der Leiterbahn;
- Verfahrensschritt H:: Spül- oder Fixierprozess, und
- Verfahrensschritt I:: Aufbringen einer Schutzschicht.

In den einzelnen Figuren wird unter Bezugnahme auf die die einzelnen Verfahrensschritte repräsentierenden Buchstaben A bis I jeweils veranschaulicht, welche Verfahrensschritte für die unterschiedlichen Varianten der Formbauteile herangezogen werden.

In Fig. 2 ist lediglich ein quadratischer Ausschnitt aus einem Formbauteil 2A dargestellt. Dieses weist einen Mehrschichtaufbau auf. Auf das Trägerbauteil 4 folgen in alternierender Reihenfolge Isolationsschichten 6 und leitfähige Ebenen 8. Die letzte der insgesamt drei dargestellten leitfähigen Ebenen 8 ist von einer Isolationsschicht 6 begrenzt, auf die zwei weitere Isolationsschichten 6A,6B aufgetragen sind, auf denen mehrere Leiterbahnen 10 aufgebracht sind. Der Mehrschichtaufbau wird oben durch eine Schutzschicht 12 abgeschlossen.

Zur Aufbringung der Leiterbahnen 10 werden insbesondere die Verfahrensschritte D bis G herangezogen. Die Leiterbahnen 10 weisen einen streckenartigen, diskreten Verlauf auf. Demgegenüber sind die leitfähigen Ebenen 8 großflächig und ohne Vorzugsrichtung ausgebildet. Sie bilden also als Ebene eine Leiterbahn, die keinen diskreten Verlauf aufweist. Vielmehr ist jede der leitfähigen Ebenen 8 an beliebigen Positionen kontaktierbar.

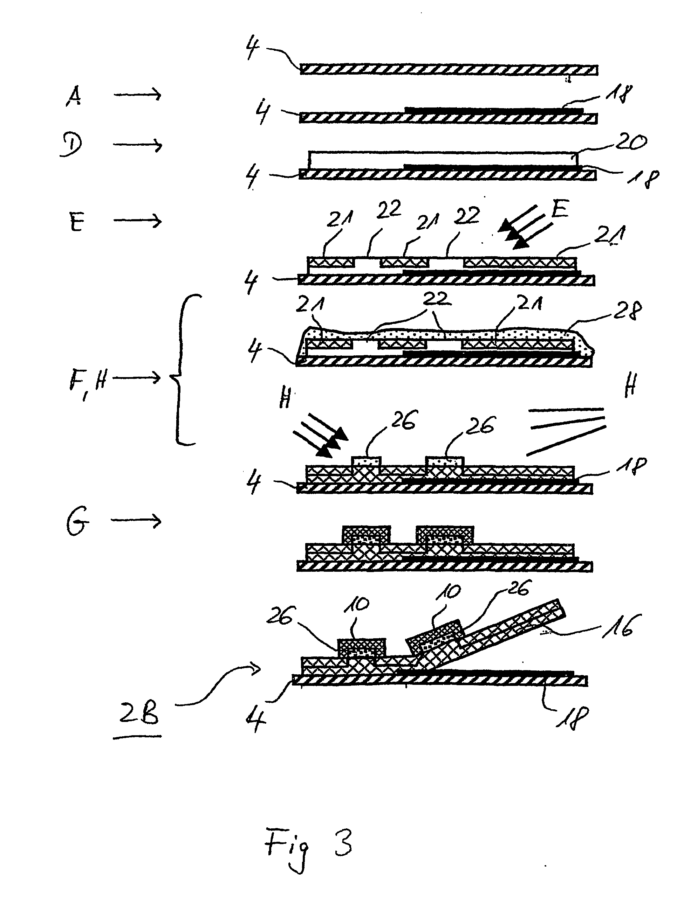

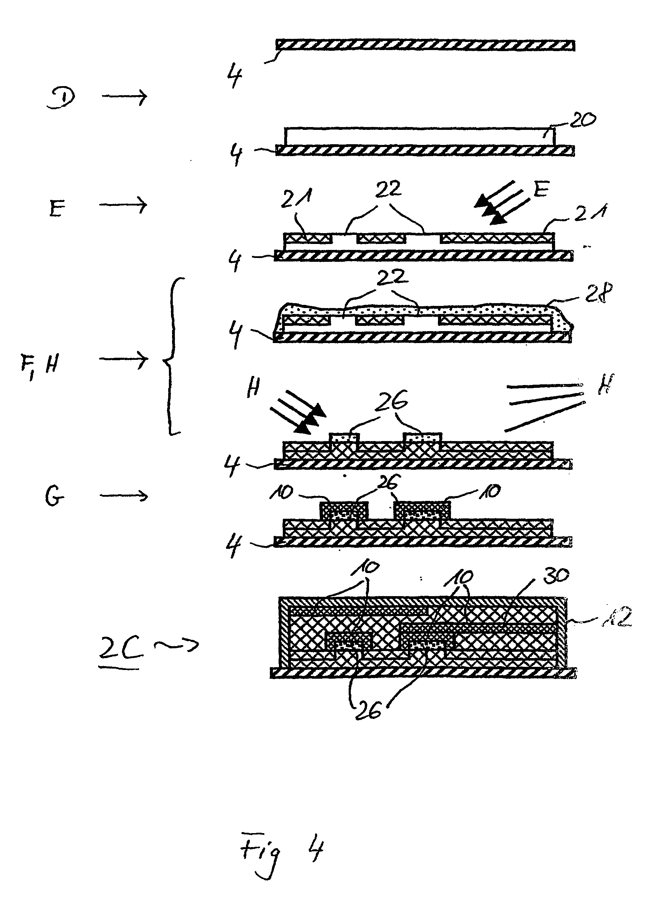

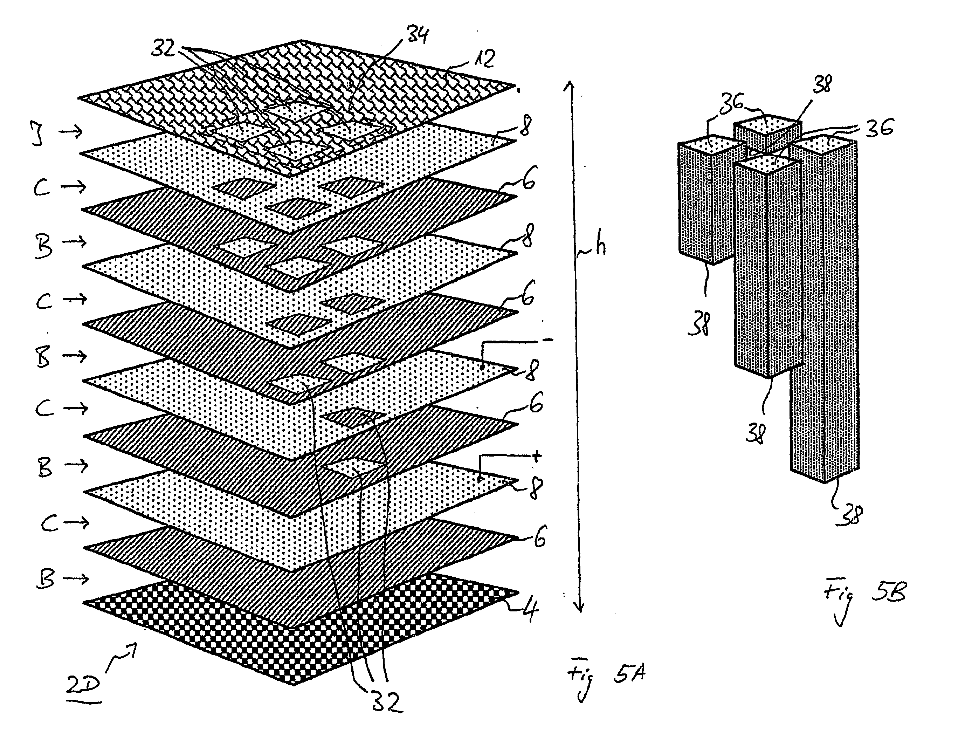

Der Mehrschichtaufbau gemäß Fig. 2 stellt demnach eine Kombination eines diskreten Leiterbahnmusters, repräsentiert durch die lsolationsebenen 6A und 6B, und der Anordnung von großflächigen leitfähigen Ebenen 8 dar. Die Variante mit dem diskreten Leiterbahnmuster wird insbesondere anhand der Figuren 2 und 3 und die Variante mit den leitfähigen Ebenen 8 insbesondere zu den Figuren 4 und 5 näher erläutert.

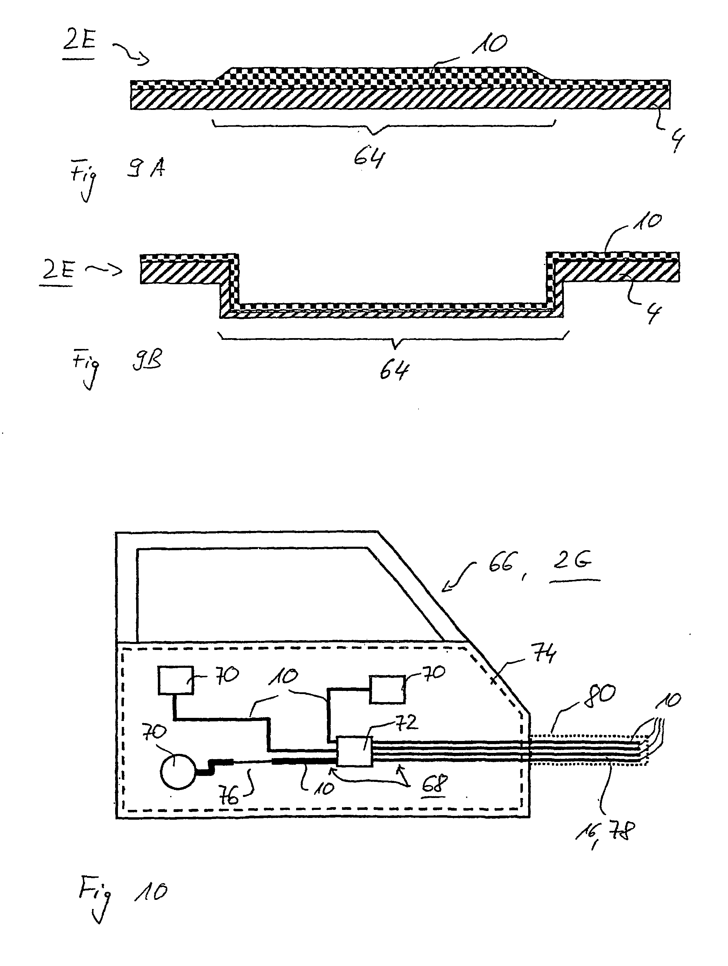

Gemäß Figur 2 weist das Trägerbauteil 4 in einem Eckbereich weiterhin eine Trennschicht 14 auf, die mit dem Verfahrensschritt A aufgebracht ist. Diese Trennschicht 14 ermöglicht ein teilweises Abheben des auf das Trägerbauteil 4 aufgebrachten mehrschichtigen Aufbaus. Ein Teilbereich 16 des mehrschichtigen Aufbaus ist also lose und nicht fest mit dem Trägerbauteil 4 verbunden. Dieser lose Teilbereich 16 ist durch eine nach oben abgebogene Ecke der einzelnen auf das Trägerbauteil 4 aufgebrachten Schichten dargestellt. Die Ausbildung des losen Teilbereichs 16 wird insbesondere zu den Figuren 3 und 10 näher erläutert.

Zur Herstellung eines Formbauteils 2B mit einer diskreten Leiterbahnstruktur wird gemäß Figur 3 folgendermaßen vorgegangen: Zunächst wird auf ein Trägerbauteil 4, beispielsweise das Blech einer Kraftfahrzeug-Tür, ein Trennelement 18 aufgelegt, das das Trägerbauteil 4 nur teilweise überdeckt (Verfahrensschritt A). Alternativ kann auch eine Trennschicht 14 aufgebracht werden. Anschließend wird das Trägerbauteil 4 und das Trennelement 18 mit einem Oberflächenmaterial überzogen. Als Oberflächenmaterial wird insbesondere ein Kautschuklack 20 verwendet (Verfahrensschritt D). Das Oberflächenmaterial wird anschließend im Verfahrensschritt E selektiv, also örtlich begrenzt, bestrahlt. Als Strahlungsquelle wird hierbei insbesondere ein Laser herangezogen. Aufgrund der Bestrahlung vemetzt der im Kautschuklack 20 zunächst unvernetzt vorliegende Kautschuk und es bilden sich vernetzte Oberflächenbereiche 21, deren Oberfläche nur noch eine geringe Haftfähigkeit hat. Die nicht bestrahlten Bereiche weisen weiterhin die ursprünglich hohe Haftfähigkeit auf, und bilden jeweils diskrete Bereiche einer Leiterbahnstruktur 22, deren Verlauf dem gewünschten Verlauf der aufzubringenden Leiterbahn 10 entspricht.

Im anschließenden Verfahrensschritt F wird auf die Leiterbahnstruktur 22 jeweils die Keim- oder Vermittlerschicht 26 aufgebracht. Hierzu wird zweistufig vorgegangen. In einer ersten Stufe wird das Pulver 28 aus einem leitfähigen Material gleichzeitig über die vemetzten Oberflächenbereiche 21 und die unvemetzten Bereiche der Leiterbahnstruktur 22 aufgetragen. Das Pulver 28 ist beispielsweise ein Kupfer-Pulver. Auf der Leiterbahnstruktur 22 bleibt das Pulver 28 haften. Von den restlichen, bereits vemetzten Oberflächenbereichen 21 wird das überschüssige Pulver 28 in einem Spülprozess (Verfahrensschritt H) abgetragen. Dies geschieht beispielsweise durch Abblasen mittels Druckluft. Weiterhin werden durch einen Fixierprozess (ebenfalls Verfahrensschritt H) die bisher unvemetzten Bereiche der Leiterbahnstruktur 22, beispielsweise durch Wärmeeinstrahlung, vernetzt. Dadurch wird die Anbindung des Pulvers 28 an den Kautschuklack 20 und damit an das Trägerbauteil 4 verbessert. Die ausgebildete Vermittlerschicht 26 dient als Haftvermittler zwischen Trägerbauteil 4 und der Leiterbahn 10.

Im anschließenden Verfahrensschritt G wird auf die Vermittlerschicht 26 die eigentliche Leiterbahn 10 aufgebracht. Dies geschieht bevorzugt mit dem Flammspritzen oder beispielsweise durch Auftragen von leitfähigem Material aus einer Schmelze mittels Wellenlöten. Alternativ hierzu bestehen auch die Möglichkeiten, eine Paste mit leitfähigem Material aufzubringen, oder das leitfähige Material aus einem Gas oder aus einem Plasma heraus aufzubringen. Weiterhin können, die Leiterbahnen 10 als leitfähige Streifen nach Art eines Laminierprozesses ausgebildet werden. Überschüssiges leitfähiges Material kann hiernach ebenfalls mittels eines Spülprozesses abgeführt werden.

Da im beschriebenen Ausführungsbeispiel zunächst ein Kupfer-Pulver 28 auf die Leiterbahnstruktur 22 aufgestreut wird, weist die als Vermittlerschicht 26 bezeichnete Schicht bereits eine Leitfähigkeit auf. Aufgrund der vielen Korngrenzen und einer möglicherweise nur sehr dünnen Schicht besteht hierbei jedoch das Problem einer nur geringen Leitfähigkeit. Durch Verbacken aufgrund eines Wärmeeinflusses der einzelnen Pulverkörner untereinander wird in einer alternativen Variante deren Leitfähigkeit erhöht, so dass die Vermittlerschicht 26 bereits selbst im Sinne einer Leiterbahn 10 ausgebildet wird. Allgemein wird zur Erhöhung der Leitfähigkeit die Leiterbahn 10 zusätzlich mit leitfähigem Material beschichtet. Hierzu eignen sich prinzipiell die gleichen Verfahren wie zum Auftragen der Leiterbahn 10.

Der so gebildete Aufbau liagt im Bereich des Trennelements 18 nur lose auf dem Trägerbauteil 4 auf, ist also nicht fest mit diesem verbunden. Dadurch lässt sich der Teilbereich 16 vom Trägerbauteil 4 abheben. Dieser lose Teilbereich 16 eignet sich in besonderer Weise beispielsweise zur Kontaktierung mit einem Stecker, da sich der Teilbereich 16 einfach in den Stecker einführen lässt.

Bevorzugt wird der gebildete Aufbau unter Druck zusammengepresst, insbesondere um die Haftung der einzelnen Schichten aneinander zu erhöhen.

Zur Ausbildung des Formbauteils 2C gemäß Figur 4 werden im Wesentlichen die gleichen Schritte vorgenommen wie zum Formbauteil 2B gemäß Fig. 3. Im Unterschied sind die Leiterbahnen 10 des Formbauteils 2C nach Fig. 3 in mehreren Schichten übereinander angeordnet. Das Formbauteil 2C ist also durch einen Mehrschichtaufbau diskreter Leiterbahnen 10 gekennzeichnet.

Der Mehrschichtaufbau des Formteils 2C unterscheidet sich von dem Mehrschichtaufbau nach Figur 2 dadurch, dass nunmehr diskrete Leiterbahnen 24 mehrschichtig übereinander angeordnet sind. Demgegenüber weist der Mehrschichtaufbau gemäß dem Formbauteil 2A nach Figur 2 eine Abfolge zwischen Isolationsschichten, leitfähigen Ebenen 8 und den Isolationsschichten 6A,6B mit den diskreten Leiterbahnmustern auf. Allenfalls die beiden übereinander liegenden Isolationsschichten 6A,6B mit den diskreten Leiterbahnmustern haben einen zu dem Formbauteil 2C gemäß Figur 4 vergleichbaren Mehrschichtaufbau.

Durch den Mehrschichtaufbau wird ein dreidimensionales Leiterbahnmuster erzeugt. Dabei können verschiedene der einzelnen Leiterbahnen 10 durch Querverbindungen 30 miteinander verbunden werden, um auch komplexe Verdrahtungsmuster zu realisieren.

Zur Ausbildung dieser dreidimensionalen Struktur werden nach Aufbringen der Leiterbahnen 10 in der ersten Ebene die Verfahrensschritte B bis G wiederholt. Dies bedeutet, dass nach Aufbringen der Leiterbahnen 10 in der ersten Ebene wiederum ein Kautschuklack 20 aufgetragen wird. Sollen Leiterbahnen 10 zweier aufeinander folgenden Ebenen miteinander kontaktiert werden, so wird im Kontaktbereich zwischen den zwei Leiterbahnen, beispielsweise zwischen der Querverbindung 30 und der darunter liegenden Leiterbahn 10, der Kautschuklack 20 wieder entfernt oder es wird dessen Aufbringen durch eine Maske verhindert.

Dieser mehrschichtige Aufbau ist insgesamt umgeben von einer Schutzschicht 12. Diese dient vorzugsweise sowohl zu Isolations- als auch zu Korrosionsschutzzwecken. Vorzugsweise ist dies eine Schicht aus PU-Material.

Das in Figur 5A nur in quadratischen Ausschnitten dargestellte Formbauteil 2D weistähnlich wie in Figur 2 dargestellt - eine alternierende Folge von Isolationsschichten 6 und leitfähigen Ebenen 8 auf, die auf einem Trägerbauteil 4 aufgebracht sind. Der Schichtaufbau wird von einer Schutzschicht 12 abgeschlossen. Die leitfähigen Ebenen 8 sind jeweils Teil eines elektrischen Bordnetzes und nehmen jeweils unterschiedliche Funktionen wahr. Vorteilhafterweise dienen dabei zwei der leitfähigen Ebenen zur Spannungsversorgung, d.h. eine der leitfähigen Ebenen 8 liegt auf einem positiven Potential und eine weitere der leitfähigen Ebenen 8 liegt auf Massepotential. Die beiden weiteren dargestellten leitfähigen Ebenen 8 dienen vorzugsweise weiterhin als Datenbusleitungen.

Dieser mehrschichtige Aufbau erstreckt sich vorzugsweise über das gesamte Formbauteil 2D. Alternativ hierzu können auch nur Teilbereiche von diesem Schichtaufbau bedeckt sein. Es können auch unterschiedliche Teilbereiche voneinander getrennte und auch unterschiedliche Schichtaufbauten aufweisen. Wesentlich ist, dass die einzelnen leitfähigen Ebenen großflächig und ohne Vorzugsorientierung auf dem Trägerbauteil 4 aufgebracht sind. Aufgrund dieser Ausgestaltung ist eine Kontaktierung prinzipiell an allen Stellen des Formbauteils 2D möglich. Dies erlaubt eine sehr flexible Handhabung und Positionierung von anzuschließenden elektrischen Komponenten, da diese auf dem Formbauteil 2D nahezu beliebig positioniert werden können. Da weiterhin nicht jede elektrische Komponente mit einem eigenen Versorgungskabel versehen ist, ist durch den dargestellten Schichtaufbau eine sehr kompakte und platzsparende Ausgestaltung ermöglicht. Dies hat insbesondere im Armaturenbereich, wo eine Vielzahl von elektrischen Komponenten anzuschließen ist, enorme Vorteile, da der nur begrenzt verfügbare Platz nicht durch einen Kabel- und Steckersalat verstopft ist.

Aufgrund der großflächigen Ausdehnung der leitfähigen Ebenen 8 können diese im Vergleich zu den diskreten Leiterbahnen 10 dünner ausgeführt werden, da aufgrund der sehr großen Fläche eine ausreichende Leitfähigkeit gewährleistet ist.

Zur Kontaktierung der einzelnen leitfähigen Ebenen 8 sind in mehreren der einzelnen Schichten 6,8,12 Kontaktierungsfenster 32 vorgesehen, die in einem Kontaktbereich 34 gruppiert sind. Die Kontaktierungsfenster 32 sind dabei derart angeordnet, dass zu jeder der leitfähigen Ebenen 8 ein entsprechender Kontaktierungsstift 36 durchführbar ist (Figur 5B). Die Kontaktierungsstifte 36 weisen dabei jeweils an ihrer unteren Stirnseite eine Berührungskontaktfläche 38 auf. Mit dieser liegen sie im kontaktierten Zustand auf der jeweiligen leitfähigen Ebene 8 plan auf. Zu einer leitfähigen Ebene 8 sind in allen über dieser Ebene 8 angeordneten Schichten 6,8,12 jeweils ein dieser leitfähigen Ebene 8 zugeordnetes Kontaktierungsfenster 32 angeordnet. Die Anzahl der nebeneinander angeordneten Kontaktierungsfenster 32 nimmt daher nach oben in Richtung zu der Schutzschicht 12 zu. Die Schutzschicht 12 weist insgesamt vier Kontaktierungsfenster 32 auf.

Vorzugsweise sind über die Oberfläche des Formbauteils 2D eine Anzahl von mehreren Kontaktbereichen 34 vorgesehen, so dass über die Kontaktstifte 36 die einzelnen leitfähigen Ebenen 8 an einer Vielzahl von Positionen kontaktierbar sind. Die Kontaktbereiche 34 können dabei beliebig über die Oberfläche verteilt angeordnet sein, um an beliebigen Stellen eine Kontaktierung von elektrischen Komponenten zu ermöglichen.

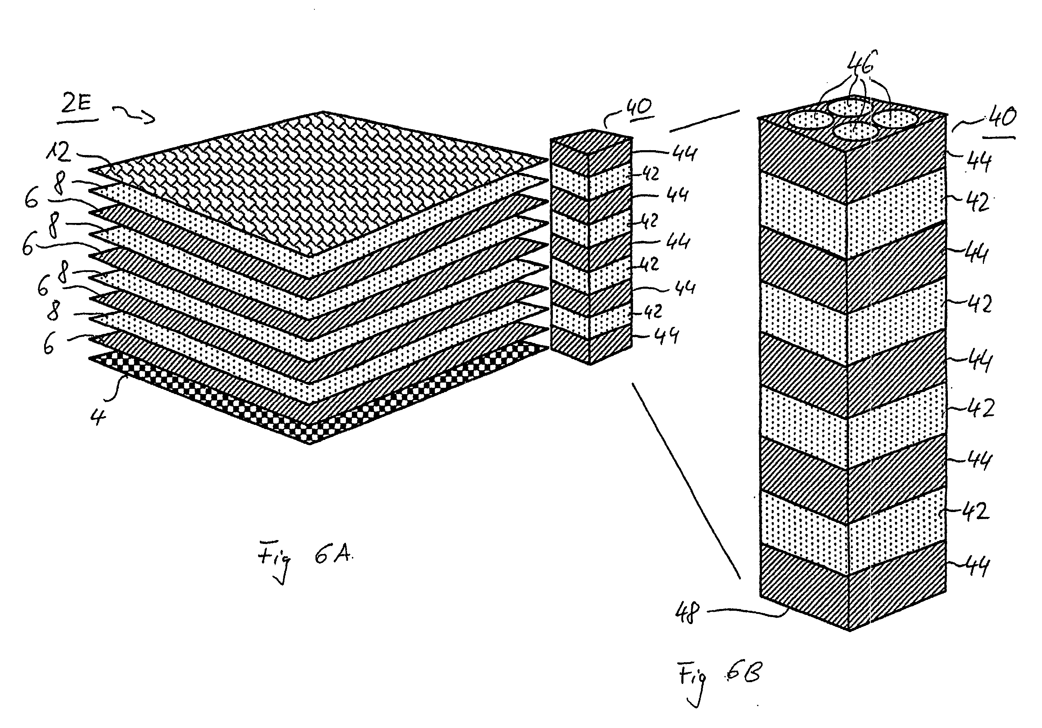

Alternativ zu der Ausgestaltung der Kontaktierungsstifte 36 mit den stimseitigen Berührungskontaktflächen 38 ist ein Kontaktstab 40 vorgesehen, wie er in Figur 6B dargestellt ist. Dieser weist über seine Länge verteilt mehrere Kontaktzonen 42 auf, die voneinander durch Isolationszonen 44 getrennt sind. Dieser alternierende Aufbau zwischen Isolationszonen 44 und Kontaktzonen 42 entspricht dem alternierenden Aufbau des in Figur 6A dargestellten Formbauteils 2E. Jede der einzelnen Kontaktzonen 42 ist mit einer Versorgungsleitung 46 verbunden, über die beispielsweise die Kontaktierung einer elektrischen Komponente erfolgt. Zur Kontaktierung der einzelnen leitfähigen Ebenen 8 mittels des Kontaktstabs 40 ist dieser vorzugsweise als Schneid-Kontaktstab ausgebildet, der nach Art der "Piercing-Methode" in den Schichtaufbau des Formbauteils 2E eingetrieben wird. Hierzu ist der Kontaktierungsstab an seinem unteren Ende 48 mit einer Schneidspitze ausgestattet (nicht dargestellt). Die einzelnen Kontaktzonen 42 kommen dabei in Berührung mit den einzelnen leitfähigen Ebenen 8. Die Methode des "Piercings" hat den Vorteil einer hohen Kontaktsicherheit, da der Kontaktstab 40 von den einzelnen leitfähigen Ebenen 8 eingeklemmt ist. Auch eine Kontaktierung an beliebigen Positionen des Formbauteils 2E möglich. Alternativ hierzu ist für den Kontaktstab 40 ebenfalls ein Kontaktierungsfenster 32 vorgesehen, durch das der Kontaktstab 40 in den Mehrschichtaufbau eingeschoben wird.

Eine weitere Variante zur Bereitstellung einer Kontaktierungsmöglichkeit, nämlich mit Hilfe eines Kontaktsteckers 56, ist in den Figuren 7A und 7B dargestellt. Der Kontaktstecker 56 wird anhand eines diskreten Leiterbahnmusters erläutert, ist jedoch gleichermaßen auch für eine Kontaktierung der flächig ausgebildeten leitfähigen Ebenen 8 geeignet.

Wie insbesondere der Figur 7B zu entnehmen ist, wird zunächst auf dem Trägerbauteil 4 beispielsweise mittels einer Klebschicht 50 ein Steckerformteil 52 aufgebracht. Anschließend wird das Trägerbauteil 4 zusammen mit dem Steckerformteil 52 mit dem Kautschuklack 20 überzogen. Daran anschließend folgen beispielsweise die Verfahrensschritte zum Erzeugen der Leiterbahnen 10, wie dies insbesondere zu der Figur 4 im Hinblick auf den Mehrschichtaufbau beschrieben wurde. Das Steckerformteil 52 ist im Ausführungsbeispiel im Querschnitt gesehen U-förmig ausgebildet und weist zwei langgestreckte Stege 54 auf, deren Länge sich über mehrere der Leiterbahnen 10 erstreckt, wie aus Figur 7A zu entnehmen ist. Durch das Überziehen des Steckerformteils 52 mit dem nachfolgenden Schichtaufbau, insbesondere mit den Leiterbahnen 10, wird am Ort dieses Steckerformteils 52 der Kontaktstecker 56 ausgebildet. An den erhabenen Positionen dieses Kontaktsteckers 56 lassen sich in einfacher Weise mit Hilfe eines komplementär zum Kontaktstecker 56 ausgebildeten Anschlusssteckers Anschlussleitungen an die einzelnen Leiterbahnen 10 anschließen. Zugleich besteht die Möglichkeit, einen derartigen Anschlussstecker als einen Funktionsstecker auszuführen, welcher über die reine Kontaktierungsfunktion weitere Funktionen übernimmt. So kann ein derartiger Funktionsstecker beispielsweise bestimmte Leiterbahnen 10 des Leiterbahnmusters miteinander verknüpfen, um im Kraftfahrzeug bestimmte elektrische Funktionen freizuschalten oder zu blockieren.

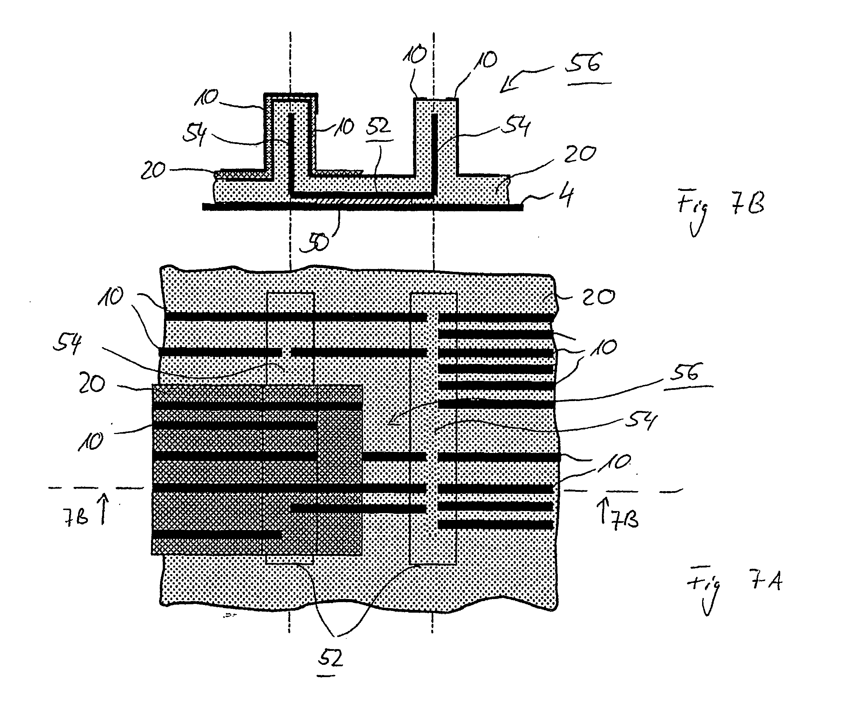

Eine besonders einfache Kontaktierungsmöglichkeit für einen Anschlussleiter 58 ist in den Figuren 8A und 8B dargestellt. Die Figur 8A zeigt dabei ausschnittsweise ein Formbauteil 2F, das den gleichen Mehrschichtaufbau hat wie das Formbauteil 2A gemäß Figur 2. Im Unterschied zu dem in Figur 2 dargestellten Formbauteil 2A sind nunmehr mehrere Anschlussleiter 58 unmittelbar mit den leitfähigen Ebenen 8 und mit einer der Leiterbahnen 10 der Isolationsschicht 6B elektrisch verbunden. Zur Kontaktierung des Anschlussleiters 58 mit der entsprechenden Leiterbahn 10 der Isolationsschicht 6A ist eine Kontaktfläche 60 aus elektrisch leitfähigem Material auf die lsolationsschicht 6A aufgebracht. Die Kontaktfläche 60 überdeckt dabei ein Teilstück der zu kontaktierenden Leiterbahn 10 und ist mit dieser elektrisch leitend verbunden.

Die Kontaktierung der Anschlussleitungen 58 erfolgt während des Schichtaufbaus. Und zwar wird dabei derart vorgegangen, dass auf die Isolationsschicht 6, die im momentanen Verfahrensschritt oben liegt, die Anschlussleitungen 58 mit ihren Leiterenden 62 aufgelegt und anschließend die leitfähigen Ebenen 8 durch einen Beschichtungsprozess aufgetragen werden. Dadurch erfolgt eine unmittelbare stoffliche Verbindung der leitfähigen Ebene 8 mit den Leiterenden 62. Um eine sichere Kontaktierung zu gewährleisten werden die Leiterenden 62 bevorzugt geeignet geformt, um eine möglichst große Kontaktfläche bereitzustellen. Hierzu sind die Leiterenden 62 beispielsweise mit Ausnehmungen, Fenstern versehen oder sind angefast oder weisen ein besonderes Profil, wie beispielsweise ein Schwalbenschwanzprofil auf.

Auch zur Kontaktierung der diskreten Leiterbahn 10 wird in dieser Weise vorgegangen. Die Leiterenden 62 werden also auf die Isolationsschicht 6B aufgelegt und anschließend wird die Kontaktfläche 60 mittels eines Beschichtungsverfahrens aufgebracht, so dass einerseits die Leiterenden 62 und andererseits die Leiterbahn 10 mit der Kontaktfläche 60 jeweils stofflich miteinander verbunden sind.

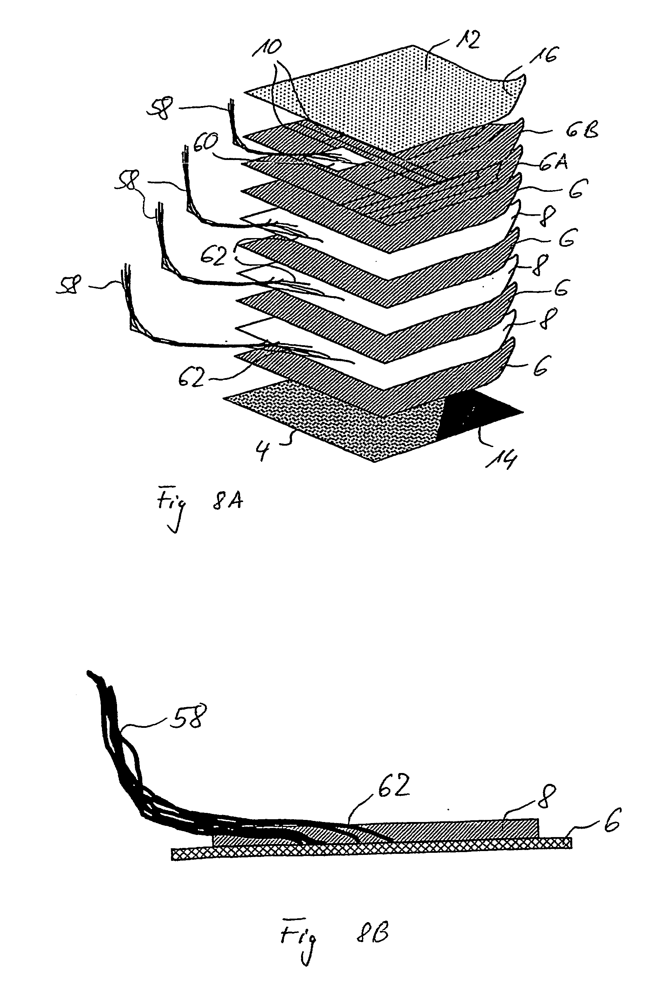

Im Kraftfahrzeug-Bereich weisen die Formbauteile 2 oftmals eine komplexe Geometrie mit einer für einen Beschichtungsprozess nur schwer zugänglichen Oberfläche auf. Gemäß einer anhand der Figuren 9A und 9B erläuterten Ausgestaltung wird daher auf ein vorzugsweise ebenes, planes Trägerbauteil 4 die Leiterbahn 10, ein gesamtes Leiterbahnmuster oder auch ein kompletter Schichtaufbau wie zu den vorangegangenen Figuren beschrieben, aufgebracht. Das Trägerbauteil 4 kann alternativ hierzu auch bereits vorgeformt sein. Wichtig ist, dass für die unterschiedlichen Beschichtungsprozesse die Oberfläche des Trägerbauteils 4 ausreichend einfach zugänglich ist. Das derart ausgebildete Formbauteil 2E wird anschließend durch einen Umformvorgang in die gewünschte Endform überführt, wie dies in Figur 9B schematisch illustriert ist. Beim Aufbringen der Leiterbahn 10 auf das zunächst plane Trägerbauteil 4 wird die Leiterbahn 10 in einem Umformbereich 64 derart dimensioniert, dass sie nach dem Umformen die gewünschten elektrischen Eigenschaften aufweist. Nach dem Ausführungsbeispiel gemäß Figure 9A und 9B wird dies dadurch erreicht, dass die Leiterbahn 10 vor dem Umformen im Umformbereich 64 dicker ausgeführt ist als in den benachbarten Bereichen. Die Dicke im Umformbereich 64 ist dabei derart bemessen, dass eine homogene und gleichbleibende Dicke der Leiterbahn 10 nach dem Umformen erreicht ist, wie dies in Figur 9B veranschaulicht ist.

In Figur 10 ist der Anwendungsfall einer Kraftfahrzeug-Tür 66 als Formbauteil 2G dargestellt. Mit dieser Tür 66 ist ein Kabelsatz 68 integral verbunden. Der Kabelsatz 68 umfasst eine Anzahl von einzelnen Leiterbahnen 10, über die einzelne elektrische Komponenten 70 angeschlossen sind. Diese elektrischen Komponenten sind beispielsweise ein Motor für einen elektrischen Fensterheber, ein Lautsprecher oder eine Vorrichtung für eine Zentralverriegelung. Weiterhin ist ein Steuergerät 72 angeordnet. Vom Steuergerät 72 werden die einzelnen Komponenten 70 angesteuert. Die einzelnen Leiterbahnen 10 des Kabelsatzes 68 sind beispielsweise unmittelbar mit einem Karosserieblech der Türe 66 verbunden. Alternativ hierzu kann der Kabelsatz 68 auch in einem sogenannten Türmodul 74 integriert sein, welches als solches mit der Tür 66 verbunden ist. Ein derartiges Türmodul 74 stellt ein Formbauteil dar und ist in Figur 10 gestrichelt dargestellt.

Eine der dargestellten Leiterbahnen 10 weist einen verjüngten Zwischenabschnitt 76 auf, in dem die Querschnittsfläche der Leiterbahn 10 verringert ist. Dieser Zwischenabschnitt 76 bildet dadurch ein elektrisches Funktionsbauteil im Sinne eines Widerstands. Derartige Funktionsbauteile lassen sich aufgrund des Herstellungsverfahrens in einfacher Weise verwirklichen. Wie gezeigt kann beispielsweise durch Variation der Leiterbahnbreite der gewünschte Widerstand genau eingestellt werden. Daneben können die Leiterbahnen 10 auch als Antennen, Kondensatoren, oder Spulen ausgebildet sein.

Für einen einfachen Anschluss des Kabelsatzes 68 an das übrige Bordnetz im Kraftfahrzeug ist ein Kabelschwanz 78 vorgesehen, der über das Formbauteit 2G übersteht. Beim Herstellen dieses Kabelschwanzes 78 wird an das Formbauteil 2G eine punktiert dargestellte Verlängerung 80 angelegt und auf diese anschließend die Leiterbahnen 10 aufgebracht, so dass die Leiterbahnen 10 sich vom Formteil 2G auf die Verlängerung 80 erstrecken. Der Kabelschwanz 78 stellt neben den Varianten mit der Trennschicht 14 (Figur 2) und dem Trennelement 18 (Figur 3) eine weitere Alternative zur Ausbildung eines losen Teilbereichs 16 dar (Verfahrensschritt A).

Durch die unmittelbare Integration der Leiterbahn 10 auf der Oberfläche des Trägerbauteils 4 ist die Leiterbahn 10 mechanisch fest und mit einer sehr geringen Aufbauhöhe mit dem Trägerbauteil 4 verbunden. Durch die geringe Aufbauhöhe ist es möglich, die Leiterbahn 10 auch um Kanten eines Blechs unterhalb einer Dichtung hindurchzuführen. Dies ist beispielsweise bei einem sogenannten Türmodulträger von Interesse, auf dem mehrere elektrische Komponenten wie Fensterheber, Lautsprecher usw. integriert sind. Die Leiterbahn 10 kann hierbei nämlich um eine Kante unter einer Dichtung, die einen äußeren Nassbereich von einem inneren Trockenbereich abdichtet, geführt werden. Damit entfällt die Notwendigkeit, aufwändig abzudichtende Kabeldurchführungen vom Nass- in den Trockenbereich vorzusehen.

Durch die mechanisch feste Verbindung mit dem Trägerbauteil 4 ist weiterhin auch eine gewisse Diebstahlsicherung gewährleistet, da beispielsweise das Kurzschließen zweiter loser Leiter nicht möglich ist. Zur zusätzlichen Absicherung kann die Leiterbahn 10 unter Zwischenschaltung einer Isolationsschicht zusätzlich durch eine insbesondere leitfähige und geerdete Sperrschicht überzogen sein.

Alternativ zu der in Figur 10 dargestellten Ausführungsvariante mit den diskreten Leiterbahnen 10 ist nach Figur 11 ein Mehrschichtaufbau aus leitfähigen Ebenen 8 für die Tür 66 vorgesehen, wie er beispielsweise in den Figuren 2,5 oder 6, dargestellt ist. Der Mehrschichtaufbau umfasst dabei entweder ausschließlich eine Abfolge von leitfähigen Ebenen 8 oder auch eine Kombination zwischen leitfähigen Ebenen 8 und einem Leiterbahnmuster mit diskreten einzelnen Leiterbahnen 10.

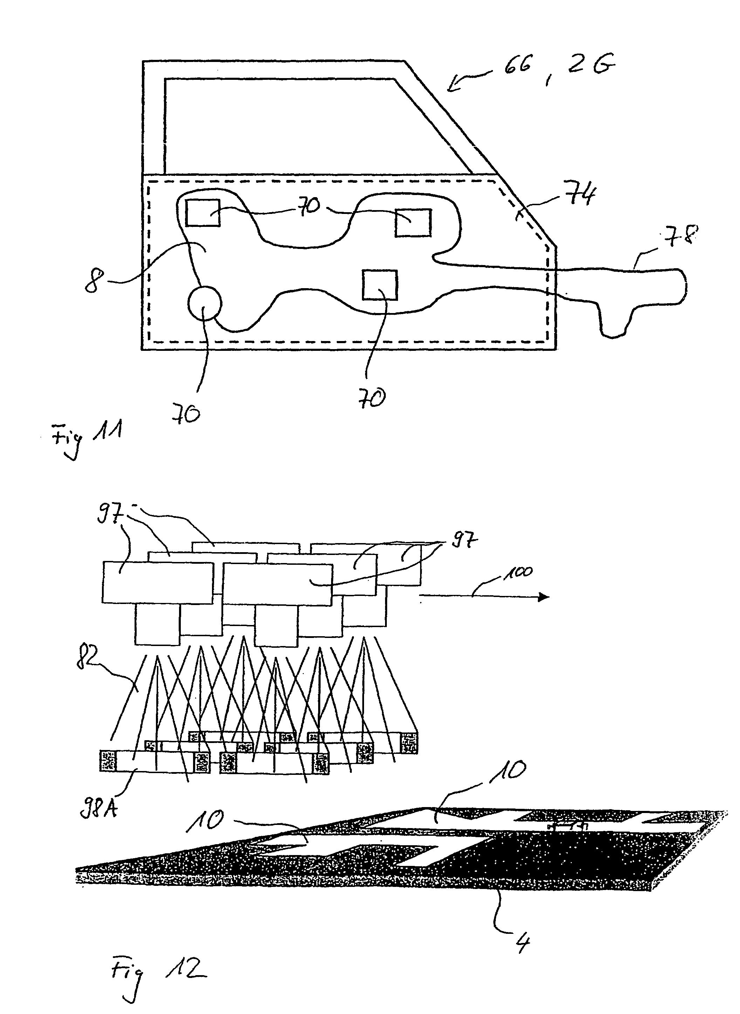

Nach Figur 12 sind für das Erzeugen der Leiterbahnen 10 insbesondere mit dem-Flammspritzen mehrere Werkzeugköpfe 97 in einem Raster nebeneinander angeordnet. Jedem der Werkzeugköpfe ist eine Blende 98A zugeordnet. Die Werkzeugköpfe 97 werden gleichzeitig betrieben, wobei jeder einzeln zu- oder abschaltbar ist. Durch die Anordnung in einem Raster lassen sich sehr schnell mehrere Leiterbahnen 10 und komplexe Leiterbahnstrukturen erzeugen.

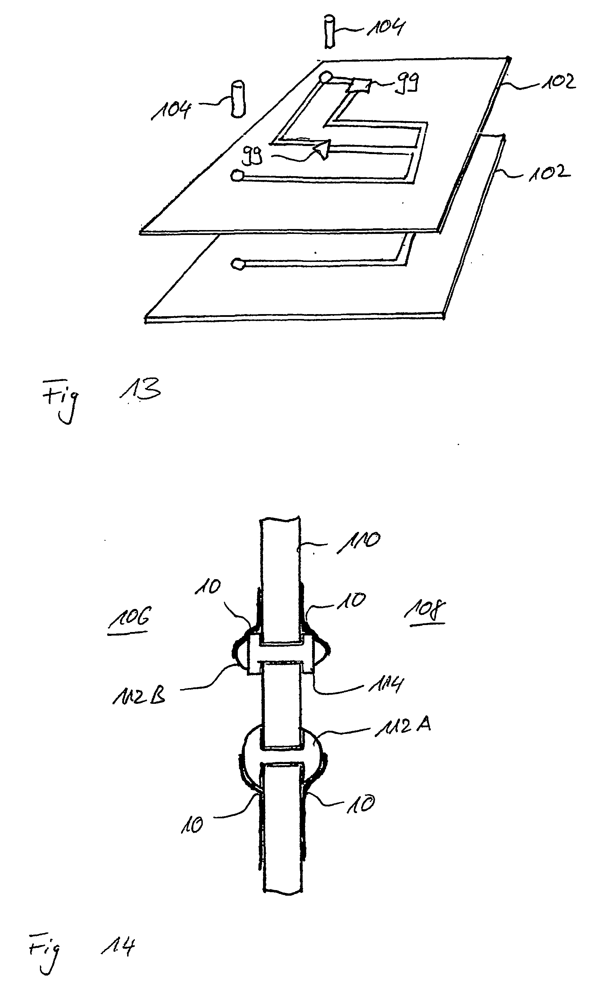

Gemäß Fig. 13 sind zwei einen Schaltungsträgerverbund bildende Schaltungsträger 102 in einer Explosionsdarstellung dargestellt, auf denen über Leitungsbahnen verbundene Bauelemente 99 angeordnet sind. Die beiden Schaltungsträger 102 sind über Kontaktelement oder direkt Kontaktstifte 104 durchkontaktiert, also miteinander elektrisch verbunden. Die Schaltungsträger 102 sind beispielsweise als Leiterplatten oder allgemein als gedruckte Leiterbahnmuster ausgebildet. Zur Kontaktierung der Schaltungsträger mit einer Leiterbahn 10 (in Figur 13 nicht dargestellt) werden die Kontaktstifte 104 herangezogen, d.h. die Leiterbahn 10 wird an die Kontaktstifte 104 geführt. Diese sind beispielsweise nach Art des zu Figur 5B beschriebenen Kontaktierungsstifts 36 oder nach Art des zur Figur 6B beschriebenen Kontaktstabs 40 ausgebildet. Insbesondere wird hierbei der Kontakt unmittelbar beim Erzeugen der Leiterbahn 10 beispielsweise durch das Flammspritzen, ausgebildet. Hierbei erfolgt eine unmittelbare stoffliche Verbindung zwischen der Leiterbahn 10 und den Kontaktstiften 104. In gleicher Art und Weise können auch Kontakte zu elektrischen Bauteilen, wie beispielsweise Motoren oder Lautsprechern, hergestellt werden.

Alternativ zu der herkömmlichen Kontaktierung der Bauelemente 99 auf dem Schaltungsträger 102 (Leiterplatte), beispielsweise durch Löten, lassen sich die Bauelemente 99 in vorteilhafter weise auch mit dem Flammspritzen schnell und einfach kontaktieren. Hierzu wird die durch das Flammspritzen erzeugte Leiterbahn 10 über entsprechende Kontaktfüße der Bauelemente gezogen. Neben der Kontaktierung der Bauelemente 99 kann zudem auch ein Leiterbahnmuster mit dem Flammspritzen auf dem Schaltungsträger 102 erzeugt werden.

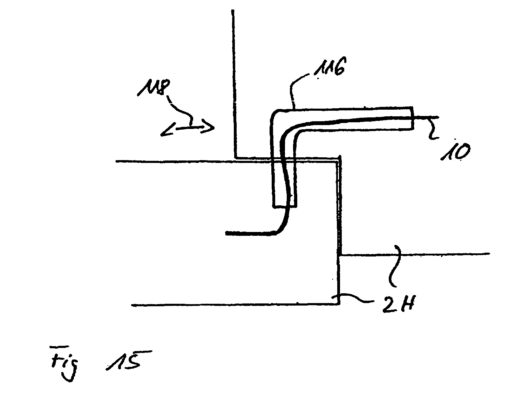

Im Kraftfahrzeugbereich ist oftmals die Durchführung einer elektrischen Leitung von einem Nassbereich 106 zu einem Trockenbereich 108 durch ein Bauteil 110 erforderlich (Figur 14). Das Bauteil 110 ist beispielsweise ein Türblech oder eine Türinnenverkleidung. Die Durchführung der Leitung durch das Bauteil 110 muss gegenüber Feuchtigkeit dicht sein. Herkömmlich werden hierzu Gummitüllen vorgesehen, durch deren Hohlraum einzelne Drahtleitungen geführt sind. Gemäß Figur 14 ist vorgesehen, dass durch das Bauteil 110 ein Kontaktelement 112A,B dichtend hindurchgeführt ist. In Figur 14 sind dabei zwei alternative Ausgestaltungen eines Kontaktelements 112A,B dargestellt. Das in der unteren Bildhälfte dargestellte Kontaktelement 112A ist als ein Vollraiet ausgebildet, der unmittelbar durch das Bauteil 110 hindurchgeführt ist. Demgegenüber ist das Kontaktelement 112B zum Bauteil 110 noch einmal speziell beispielsweise mit einer Isolier- oder Gummihülse 114 abgedichtet. Das Kontaktelement 112B ist dabei durch die Gummihülse 114 hindurchgeführt. Die Gummihülse 114 ist insbesondere dann erforderlich, wenn das Bauteil 110 selbst leitfähig ist, so dass das Kontaktelement 112B zum Bauteil 110 hin isoliert sein muss. Beidseitig an den Kontaktelementen 112A,B sind jeweils Leiterbahnen 10 unmittelbar kontaktiert, so dass eine elektrische Verbindung vom Nassbereich 106 in den Trockenbereich 108 gegeben ist.

Nach Figur 15 ist eine Leiterbahn 10 über den Stoßbereich zweier aneinander angrenzender Formbauteile 2H geführt. Im Stoßbereich der beiden Formbauteile 2H ist die Leiterbahn 10 auf einer Ausgleichsschicht 116 aufgebracht, die auf den beiden Formbauteilen 2H jeweils nur schwimmend gelagert ist, also auf diesen nur lose aufliegt. Im Anschluss an die Ausgleichsschicht 116 ist die Leiterbahn 10 fest mit den jeweiligen Formbauteilen 2H verbunden. Tritt zwischen den beiden Formbauteilen 2H eine Schubspannung in Querrichtung 118 beispielsweise aufgrund von mechanischen oder thermischen Beanspruchungen auf, so wird diese Schubspannung von der insbesondere flexibel ausgebildeten Ausgleichsschicht 116 aufgenommen und nicht auf die Leiterbahn 10 übertragen. Die Ausgleichsschicht 116 ist insbesondere ein Kautschuklack, der durch entsprechende anschließende Behandlung, insbesondere Vernetzung, von den Trägerbauteilen 4 der jeweiligen Formbauteile 2H abgelöst ist.

### Bezugszeichenliste

- 2A-2l: Formbauteil
- 4: Trägerbauteil
- 5: Oberflächenschicht
- 5A: Haftbereich
- 6,6A,6B: Isolationsschicht
- 7: Bestrahlungssystem
- 7A: Strahlungsquelle
- 7B: Linse
- 7C: Strahlengang
- 8: leitfähige Ebene
- 9: Zuführrohr
- 10: Leiterbahn
- 12: Schutzschicht
- 14: Trennschicht
- 16: Teilbereich
- 18: Trennelement
- 20: Kautschuklack
- 22: Leiterbahnbereich
- 25: vernetzter Bereich
- 26: Keim- Vermittlerschicht
- 28: Pulver
- 30: Querverbindung
- 32: Kontaktierungsfenster
- 34: Kontaktbereich
- 36: Kontaktierungsstift
- 38: Berührungskontakt-fläche
- 40: Kontaktstab
- 42: Kontaktzone
- 44: Isolationszone
- 46: Versorgungsleitung
- 48: Ende
- 50: Klebschicht
- 52: Steckerformteil
- 54: Stege
- 56: Kontaktstecker
- 58: Anschlussleiter
- 60: Kontaktfläche
- 62: Leiterende
- 64: Umformbereich
- 66: Tür
- 68: Kabelsatz
- 70: elektrische Komponente
- 72: Steuergerät
- 74: Türmodul
- 76: Zwischenabschnitt
- 78: Kabelschwanz
- 80: Verlängerung
- 82: Teilchenstrahl

- 97: Werkzeugkopf
- 98: Düse
- 98A: Blende
- 99: Bauelement
- 100: Vorschubrichtung
- 102: Schaltungsträger
- 104: Kontaktstift
- 106: Nassbereich
- 108: Trockenbereich
- 110: Bauteil
- 112A,B: Kontaktelement
- 114: Gummihülse
- 116: Ausgleichsschicht
- 118: Querrichtung
- 120: Schlauch
- h: Höhe Schichtaufbau
- T: Teilchen

## Patentansprüche

1. Verfahren zum Herstellen eines Kraftfahfzeug-Formbauteils (2A-2J,4) wie eine Tür, ein Türmodul, ein Halbzeug (Blech) oder der Amaturenbereich, bei dem unmittelbar auf dem Formbauteil (24A-2J,4) eine Leiterbahn (10), aufgebracht wird so dass die Leiterbahn (10) mit dem Fortnbauteil (24A-2J,4) integral verbunden ist, indem
a) die Oberfläche des Formbauteils (24A-2J,4) selektiv entsprechend einem vorgesehenen Verlauf der Leiterbahn (10) behandelt wird, so dass die Oberfläche Bereiche unterschiedlicher Haftung aufweist,
b) im vorgesehenen Verlauf der Leiterbahn (10) eine Keimschicht (26) aufgetragen wird und wobei
c) auf die Keimschicht (26) die Leiterbahn (10) aufgebracht wird.

2. Verfahren nach Anspruch 1, bei dem die Leiterbahn (10) mit einem strahlgebundenen thermisch-kinetischen Auftragsverfahren, insbesondere mit dem Flammspritzen, aufgebracht wird.

3. Verfahren nach Anspruch 2, bei dem als ein Trägergas für einen Teilchenstrahl (82) bei dem strahlgebundenen Auftragsverfahren ein Inertgas verwendet wird.

4. Verfahren nach Anspruch 2 oder Anspruch 3, bei dem dem Teilchenstrahl (82) neben leitfähigen Teilchen zusätzlich nicht leitfähige Verunreinigungen, insbesondere Silizium, beigemischt werden.

5. Verfahren nach einem der vorhergehenden Ansprüche, bei dem die Leiterbahn (10) aus einer Schmelze aufgebracht wird, und hierzu insbesondere das Formbauteil (2A-2J,4) mit der Keimschicht (26) durch ein Schmelzbad zur Aufbringung der Leiterbahn (10) gezogen wird.

6. Verfahren nach einem der vorhergehenden Ansprüche, bei dem mehrere der Verfahrensschritte a-c von einer Bearbeitungsvorrichtung ausgeführt werden.

7. Verfahren nach einem der vorhergehenden Ansprüche, bei dem die Hafteigenschaft der Oberfläche des Formbauteils (2A-2J,4) verändert wird, indem wahlweise
- die Oberfläche mit einem vernetzbaren Stoff (20) oder mit einem aushärtbaren Stoff beschichtet wird, dessen Hafteigenschaft durch anschließende örtlich selektive Vemetzung bzw. Aushärtung verändert wird,
- eine chemisch aktive Substanz aufgebracht wird, die die Oberfläche bezüglich der Hafteigenschaft verändert,
- die Oberfläche durch Wärmezufuhr behandelt wird,
- die Oberfläche elektrostatisch aufgeladen wird,
- selektiv eine Haftschicht auf die Oberfläche aufgebracht wird.

8. Verfahren nach einem der vorhergehenden Ansprüche, bei dem die Keimschicht (26) aufgebracht wird, indem wahlweise
- ein Pulver (28) auf die Oberfläche aufgebracht wird,
- das Formbauteil (2A-2J,4) durch ein Pulverbad gezogen wird,
- eine metallischen Suspension auf das Formbauteil (2A-2J,4) aufgebracht wird.

9. Verfahren nach einem der vorhergehenden Ansprüche, bei dem die Keimschicht (26) im vorgesehenen Verlauf der Leiterbahn (10) Unterbrechungen aufweist.

10. Verfahren nach einem der vorhergehenden Ansprüche, bei dem die Leiterbahn (10) teilweise auf einer Ausgleichsschicht (116) aufgebracht wird, die mit dem Formbauteil (2A-2J,4) schwimmend verbunden ist.

11. Verfahren nach einem der vorhergehenden Ansprüche, bei dem die Materialstruktur der aufgebrachten Leiterbahn (10) verändert wird.

12. Verfahren nach einem der vorhergehenden Ansprüche, bei dem die aufgebrachte Leiterbahn (10) mit einer Beschichtung zur Erhöhung der Leitfähigkeit und/oder mit einer Schutzschicht (12) versehen wird.

13. Verfahren nach einem der vorhergehenden Ansprüche, bei dem die Leiterbahn (10) oder mehrere Leiterbahnen (10) derart aufgebracht wird bzw. werden, dass ein elektrisches Funktionsbauteil (76) geschaffen ist.

14. Verfahren nach einem der vorhergehenden Ansprüche, bei dem mehrere zueinander isolierte Leiterbahnen (10) in Schichten übereinander angeordnet werden.

15. Verfahren nach einem der vorhergehenden Ansprüche, bei dem schichtweise angeordnete großflächige leitfähige Ebenen (8) ausgebildet werden, die Teil eines elektrischen Netzes sind und unterschiedliche Funktionen für das Netz wahrnehmen.

16. Verfahren nach einem der vorhergehenden Ansprüche, bei dem die Leiterbahn (10) teilweise vom Formbauteil (2A-2J,4) abtrennbar aufgebracht wird.

17. Verfahren nach Anspruch 15, bei dem vor dem Aufbringen der Leiterbahn (10) eine Trennschicht (14) oder ein Trennelement (18) aufgebracht wird.

18. Verfahren nach einem der vorhergehenden Ansprüche, bei dem an das Formbauteil (2A-2J,4) eine Verlängerung (80) angelegt wird und die Leiterbahn (10) vom Formbauteil (2A-2J,4) auf die Verlängerung (80) erstreckend zur Ausbildung eines Kabelschwanzes (78) aufgebracht wird.

19. Verfahren nach einem der vorhergehenden Ansprüche, bei dem zur Kontaktierung eines Anschlussleiters (58) dieser mit einem Leiterende (62) auf das Formbauteil (2A-2J,4) gelegt und durch das anschließende Aufbringen der Leiterbahn (10) mit dieser elektrisch leitend verbunden wird.

20. Verfahren nach einem der vorhergehenden Ansprüche, bei dem auf das Formbauteil (2A-2J,4) ein Steckerformteil (52) aufgebracht wird, das anschließend zumindest teilweise mit einem Teilstück der Leiterbahn (10) überzogen wird, wodurch ein Kontaktstecker (56) erzeugt wird.

21. Verfahren nach einem der vorhergehenden Ansprüche, bei dem die Leiterbahn mit einem Schaltungsträger (104) oder einem Schaltungsträgerverbund kontaktiert wird, indem in den Schaltungsträger (102) bzw. Schaltungsträgerverbund ein Kontaktelement (104) eingebracht wird, und die Leiterbahn (10) mit dem Kontaktelement (104) kontaktiert wird.

22. Verfahren nach einem der Ansprüche 2 bis 21, bei dem ein elektrisches Bauelement (99) durch die mit dem strahlgebundenen Auftragsverfahren erzeugte Leiterbahn (10) kontaktiert wird.

23. Verfahren nach einem der vorhergehenden Ansprüche, bei dem das Formbauteil (2A-2J,4) nach dem Aufbringen der Leiterbahn (10) durch einen Umformprozess in die gewünschte Endform gebracht wird.

24. Verfahren nach Anspruch 23, bei dem die Leiterbahn (10) in einem Umformbereich (64) des Formbauteils (2A-2J,4) derart dimensioniert wird, dass die Leiterbahn (10) nach dem Umformen des Formbauteils (2A-2J,4) die gewünschten elektrischen Eigenschaften aufweist.

25. Kraftfahrzeug-Formbauteil (2A-2J,4) wie eine Tür, ein Türmodul, ein Halbzeug (Blech) oder der Armaturenbereich mit einer Leiterbahn (10), die mit dem Verfahren nach einem der vorhergehenden Ansprüche auf das Formbauteil (2A-2J,4) aufgebracht und mit diesem integral verbunden ist.

## Claims

1. Method for producing a motor vehicle moulding (2A-2J, 4) such as a door, a door module, a semi-finished product (panel) or the dashboard area, in which a conductor run (10) is applied directly to the moulding (24A-2J, 4) such that the conductor run (10) is integrally connected to the moulding (24A-2J, 4), in that
a) the surface of the moulding (24A-2J, 4) is treated selectively in a corresponding manner to a profile which is provided for the conductor run (10), such that the surface has areas of different adhesion,
b) a germination layer (26) is applied in the profile which is provided for the conductor run (10), and
c) the conductor run (10) being applied to the germination layer (26).

2. Method according to Claim 1, in which the conductor run (10) is applied by means of a beam thermal/kinetic application method, in particular by gas flame spraying.

3. Method according to Claim 2, in which an inert gas is used as a carrier gas for a particle beam (82) for the beam application method.

4. Method according to Claim 2 or Claim 3, in which, in addition to conductive particles, nonconductive impurities, in particular silicon, are additionally added to the particle beam (82).

5. Method according to one of the preceding claims, in which the conductor run (10) is applied from a melt, and for this purpose the moulding (2A-2J, 4) is, in particular, drawn together with the germination layer (26) through a melt bath in order to apply the conductor run (10).

6. Method according to one of the preceding claims, in which two or more of the method steps a-c are carried out by one processing apparatus.

7. Method according to one of the preceding claims, in which the adhesion characteristic of the surface of the moulding (2A-2J, 4) is varied in that, optionally,
- the surface is coated with a substance (20) which can be crosslinked or with a substance which can be cured, whose adhesion characteristic is varied by subsequent locally selective crosslinking or curing,
- a chemically active substance is applied that varies the adhesion characteristic of the surface,
- the surface is treated by supplying heat,
- the surface is electrostatically charged, or
- an adhesion layer is selectively applied to the surface.

8. Method according to one of the preceding claims, in which the germination layer (26) is applied in that, optionally,
- a powder (28) is applied to the surface,
- the moulding (2A-2J, 4) is drawn through a powder bath or
- a metallic suspension is applied to the moulding (2A-2J, 4).

9. Method according to one of the preceding claims, in which the germination layer (26) has interruptions in the profile which is provided for the conductor run (10).

10. Method according to one of the preceding claims, in which the conductor run (10) is partially applied on a compensating layer (116) which is connected to the moulding (2A-2J, 4) in a floating manner.

11. Method according to one of the preceding claims, in which the material structure of the applied conductor run (10) is varied.

12. Method according to one of the preceding claims, in which the applied conductor run (10) is provided with a coating in order to increase the conductivity and/or is provided with a protective layer (12).

13. Method according to one of the preceding claims, in which the conductor run (10) or two or more conductor runs (10) is or are applied such that an electrical functional component (76) is produced.

14. Method according. to one of the preceding claims, in which two or more conductor runs (10) which are isolated from one another are arranged one above the other in layers.

15. Method according to one of the preceding claims, in which large-area conductive levels (8) which are arranged in layers are formed, are part of an electrical power supply system, and carry out different functions for the power supply system.

16. Method according to one of the preceding claims, in which the conductor run (10) is partially applied such that it can be disconnected from the moulding (2A-2J, 4).

17. Method according to Claim 15, in which an isolating layer (14) or an isolating element (18) is applied before the application of the conductor run (10).

18. Method according to one of the preceding claims, in which an extension (80) is applied to the moulding (2A-2J, 4), and the conductor run (10) is applied from the moulding (2A-2J, 4), extending to the extension (80), in order to form a pigtail (78).

19. Method according to one of the preceding claims, in which, in order to make contact with a connecting conductor (58), one conductor end (62) of this connecting conductor (58) is placed on the moulding (2A-2J, 4) and is electrically conductively connected to the conductor run (10) when the latter is subsequently applied.

20. Method according to one of the preceding claims, in which a plug moulding (52) is fitted to the moulding (2A-2J, 4) and is subsequently at least partially coated with a piece of the conductor run (10), thus producing a contact plug (56).

21. Method according to one of the preceding claims, in which the conductor run makes contact with a circuit mount (104) or with a circuit mount assembly, in that a contact element (104) is incorporated in the circuit mount (102) or in the circuit mount assembly, and the conductor run (10) makes contact with the contact element (104).

22. Method according to one of Claims 2 to 21, in which the conductor run (10) which is produced by the beam application method makes contact with an electrical component (99).

23. Method according to one of the preceding claims. in which the moulding (2A-2J, 4) is changed to the desired final shape by means of a forming process after the application of the conductor run (10).

24. Method according to Claim 23, in which the conductor run (10) is dimensioned in a forming area (64) of the moulding (2A-2J, 4) such that the conductor run (10) has the desired electrical characteristics after the forming of the moulding (2A-2J, 4).

25. Motor vehicle moulding (2A-2J, 4) such as a door, a door module, a semi-finished product (panel) or the dashboard area, having a conductor run (10) which is applied to the moulding (2A-2J, 4) and is integrally connected to it, using the method according to one of the preceding claims.

## Revendications

1. Procédé de fabrication d'un composant moulé pour véhicules automobiles (2A-2J,4), comme une porte, un module de porte, un produit semi-fini (tôle), ou la région du tableau de bord, dans lequel on applique le directement sur le composant moulé (24A-2J,4) une piste conductrice (10), de sorte que la piste conductrice (10) est reliée de manière intégrale avec le composant moulé (24A-2J,4), dans lequel
a) la surface du composant moulé (24A-2J,4) est traitée de manière sélective en correspondance d'un tracé prévu pour la piste conductrice (10) de telle sorte que la surface présente des zones d'adhérence différente,
b) sur le tracé prévu pour la piste conductrice (10) on applique une couche de germination (26), et
c) la piste conductrice (10) est appliquée sur la couche de germination (26).

2. Procédé selon la revendication 1, dans lequel la piste conductrice (10) est appliquée avec un procédé d'application thermique-cinétique associé à un jet, en particulier par projection à la flamme.

3. Procédé selon la revendication 2, dans lequel on utilise un gaz inerte à titre de gaz propulseur pour un jet de particules (82) dans le procédé d'application associé à un jet.

4. Procédé selon l'une ou l'autre des revendications 2 est 3, dans lequel on mélange au jet de particules (82), outre des particules conductrices, additionnellement des impuretés non conductrices, en particulier du silicium.

5. Procédé selon l'une des revendications précédentes, dans lequel la piste conductrice (10) est appliquée depuis un bain de fusion, et en ce qu'à cet effet le composant moulé (2A-2J,4) avec la couche de germination (26) est en particulier tiré à travers un bain de fusion pour appliquer la piste conductrice.

6. Procédé selon l'une des revendications précédentes, dans lequel plusieurs des étapes de procédé a-c sont exécutées par un dispositif de traitement.

7. Procédé selon l'une des revendications précédentes, dans lequel la propriété d'adhérence de la surface du composant moulé (2A-2J,4) est modifiée en ce que, au choix :
-- la surface est modifiée avec un matériau réticulable (20) ou avec un matériau durcissable, dont la propriété d'adhérence est modifiée par réticulation ou par durcissement local successif sélectif,
-- une substance chimiquement active est appliquée, qui modifie la surface pour ce qui concerne sa propriété d'adhérence,
-- la surface est traitée par apport de chaleur,
-- la surface est chargée de manière électrostatique,
-- une couche d'adhérence est appliquée de manière sélective sur la surface.

8. Procédé selon l'une des revendications précédentes, dans lequel la couche de germination (26) est appliquée en ce que, au choix :
-- on applique une poudre (28) sur la surface,
-- le composant moulé (2A-2J,4) est tiré à travers un bain de poudre,
-- une suspension métallique est appliquée sur le composant moulé (2A-2J,4).

9. Procédé selon l'une des revendications précédentes, dans lequel la couche de germination (26) comporte des interruptions dans le tracé prévu pour la piste conductrice (10).

10. Procédé selon l'une des revendications précédentes, dans lequel la piste conductrice (10) est appliquée partiellement sur une couche de compensation (116) qui est reliée en flottement au composant moulé (2A-2J,4).

11. Procédé selon l'une des revendications précédentes, dans lequel la structure du matériau de la piste conductrice appliquée (10) est modifiée.

12. Procédé selon l'une des revendications précédentes, dans lequel la piste conductrice appliquée (10) est pourvue d'un revêtement pour augmenter la conductibilité et/ou d'une couche protectrice (12).

13. Procédé selon l'une des revendications précédentes, dans lequel la piste conductrice (10) ou plusieurs pistes conductrices (10) est/sont appliquée(s) en réalisant un composant fonctionnel électrique (76).

14. Procédé selon l'une des revendications précédentes, dans lequel plusieurs pistes conductrices isolées (10) sont agencées en couches les unes au-dessus des autres.

15. Procédé selon l'une des revendications précédentes, dans lequel on réalise des éléments conducteurs à grande surface (8) agencés en couche, qui font partie d'un réseau électrique, et qui remplissent des fonctions différentes pour le réseau.

16. Procédé selon l'une des revendications précédentes, dans lequel les pistes conductrices (10) sont appliquées de manière à pouvoir être séparées partiellement depuis le composant moulé (2A-2J,4).

17. Procédé selon la revendication 15, dans lequel, avant d'appliquer la piste conductrice (10), on applique une couche de séparation (14) ou un élément de séparation (18).

18. Procédé selon l'une des revendications précédentes, dans lequel on ajoute au composant moulé (2A-2J,4) un prolongement (80), et la piste conductrice (10) est appliquée depuis le composant moulé (2A-2J,4) en s'étendant jusque sur le prolongement (80) pour réaliser une queue de câble (78).

19. Procédé selon l'une des revendications précédentes, dans lequel, pour la mise en contact d'un conducteur de raccordement (58), celui-ci est posé avec une extrémité (62) sur le composant moulé (2A-2J,4), et est relié de manière électroconductrice à la piste conductrice (10) par l'application successive de celle-ci.

20. Procédé selon l'une des revendications précédentes, dans lequel on applique une pièce moulée formant prise (52) sur le composant moulé (2A-2J,4), qui est ensuite recouverte au moins partiellement d'un morceau partiel de la piste conductrice (10), grâce à quoi on engendre une prise de contact (56).

21. Procédé selon l'une des revendications précédentes, dans lequel la piste conductrice est mise en contact avec un porte-circuit (104), ou un porte-circuit composite, en ce que l'on introduit dans le porte-circuit (102) ou dans le porte-circuit composite un élément de contact (104), et la piste conductrice (10) est mise en contact avec l'élément de contact (104).

22. Procédé selon l'une des revendications 2 à 21, dans lequel un élément structurel électrique est contacté par la piste conductrice (10) engendré par le procédé d'application associé à un jet.

23. Procédé selon l'une des revendications précédentes, dans lequel le composant moulé (2A-2J,4) est amené sous la forme finale désirée après application de la piste conductrice (10) via un processus de mise en forme.

24. Procédé selon la revendication 23, dans lequel la piste conductrice (10) est dimensionnée, dans une zone de mise en forme (64) du composant moulé (2A-2J,4) de telle manière que la piste conductrice (10) présente les propriétés électriques souhaitées après mise en forme du composant moulé (2A-2J,4).

25. Composant moulé (2A-2J,4) pour véhicule automobile, comme une porte, un module de porte, un produit semi-fini (tôle) ou la zone de tableau de bord, avec une piste conductrice (10), qui est appliquée par le procédé selon l'une des revendications précédentes sur le composant moulé (2A-2J,4) et est reliée de manière intégrale avec celui-ci.
